(19) Europäisches Patentamt
European Patent Office
Office européen des brevets

(11) **EP 4 395 462 A1**

(12) **EUROPEAN PATENT APPLICATION**

(43) Date of publication:
**03.07.2024 Bulletin 2024/27**

(21) Application number: **24150031.3**

(22) Date of filing: **02.01.2024**

(51) International Patent Classification (IPC):
**H05B 33/14** (2006.01)     **H05B 33/22** (2006.01)

(52) Cooperative Patent Classification (CPC):
**H05B 33/14; H05B 33/22**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**KH MA MD TN**

(30) Priority: **30.12.2022 KR 20220191006**

(71) Applicant: **Samsung Electronics Co., Ltd.**
**Suwon-si, Gyeonggi-do 16677 (KR)**

(72) Inventors:
• **KIM, Sung Woo**
**16678 Suwon-si (KR)**

• **KIM, Chan Su**
**16678 Suwon-si (KR)**
• **LEE, Ilyoung**
**16678 Suwon-si (KR)**
• **CHUNG, You Jung**
**16678 Suwon-si (KR)**
• **HAN, Moon Gyu**
**16678 Suwon-si (KR)**

(74) Representative: **Elkington and Fife LLP**
**Prospect House**
**8 Pembroke Road**
**Sevenoaks, Kent TN13 1XR (GB)**

(54) **ELECTROLUMINESCENT DEVICE, PRODUCTION METHOD THEREOF, AND DISPLAY DEVICE INCLUDING THE SAME**

(57) Disclosed are an electroluminescent device including a first electrode and a second electrode spaced apart from each other; a light-emitting layer disposed between the first and second electrodes; and an electron transport layer between the light-emitting layer and the second electrode; a production method thereof; and a display device including the same. The light-emitting layer includes a semiconductor nanoparticle, the electron transport layer includes a zinc oxide nanoparticle having a size of 1 nm or more to 15 nm or less, and the zinc oxide nanoparticle further includes magnesium and aluminum, and an amount of aluminum in the zinc oxide nanoparticle is greater than or equal to about 0.5 mol% and less than or equal to about 30 mol% based on a total amount of zinc, magnesium, and aluminum.

FIG. 1

EP 4 395 462 A1

**Description**

FIELD OF THE INVENTION

The present disclosure relates to a light-emitting (e.g., electroluminescent) device, a production method thereof, and a display device including the electroluminescent device.

BACKGROUND OF THE INVENTION

A semiconductor nanoparticle (e.g., a semiconductor nanocrystal particle) having a size in the nanometer range may exhibit luminescent properties. For example, a quantum dot including a semiconductor nanocrystal may exhibit a quantum confinement effect. The light emission from the semiconductor nanoparticle may occur when an electron in an excited state resulting from light excitation or an applied voltage moves from a conduction band to a valence band. The semiconductor nanoparticle may emit light of a desired wavelength region by adjusting a size of the semiconductor nanoparticle, a composition of the semiconductor nanoparticle, or a combination thereof.

The semiconductor nanoparticle may be used, for example, in a light-emitting device (e.g., an electroluminescent device) or a display device including the electroluminescent device. There remains a need for an improved light-emitting device.

SUMMARY OF THE INVENTION

An embodiment provides a light-emitting device that emits light, for example, by applying a voltage to a nanostructure (e.g., a semiconductor nanoparticle such as a quantum dot), for example with or without a separate irradiation light source.

An embodiment provides a display device (e.g., a quantum dot-light-emitting diode (QD-LED) display device) that includes a semiconductor nanoparticle such as a quantum dot as a component of a light-emitting layer in a pixel configuration (e.g., in a configuration of a blue pixel, a red pixel, a green pixel, or a combination thereof).

In an embodiment, an electroluminescent device includes:

a first electrode and a second electrode spaced apart from each other (e.g., each electrode having a surface opposite the other);
a light-emitting layer disposed between the first electrode and the second electrode; and
an electron transport layer disposed between the light-emitting layer and the second electrode,
wherein the light-emitting layer includes a semiconductor nanoparticle (e.g., a plurality of semiconductor nanoparticles),
wherein the electron transport layer includes a zinc oxide nanoparticle (e.g., a plurality of zinc oxide nanoparticles),
wherein the zinc oxide nanoparticle has a size of 1 nanometer or greater and 15 nanometers or less,
wherein the zinc oxide nanoparticle includes magnesium and aluminum,
and wherein in the zinc oxide nanoparticle, an amount of aluminum is greater than or equal to about 0.5 mol% and less than or equal to about 30 mol%, based on a total amount of zinc, magnesium, and aluminum.

The light-emitting layer may be configured to emit a first light. The first light may have a peak emission wavelength of from about 440 nm to less than or equal to about 480 nm.

The electroluminescent device may further include a hole auxiliary layer between the light-emitting layer and the first electrode. The hole auxiliary layer may include a hole transport layer (e.g., including an organic compound), a hole injection layer, or a combination thereof.

The semiconductor nanoparticle, or the light-emitting layer, may not include cadmium.

The semiconductor nanoparticle, or the light-emitting layer, may not include lead, mercury, or a combination thereof.

The semiconductor nanoparticle may include a first semiconductor nanocrystal including zinc, selenium, and tellurium, and a second semiconductor nanocrystal including a zinc chalcogenide, the second semiconductor nanocrystal being different from the first semiconductor nanocrystal.

The semiconductor nanoparticle may include a first semiconductor nanocrystal including (a Group III-V compound or an indium phosphide compound including) indium, phosphorus, and optionally zinc; and a second semiconductor nanocrystal including a zinc chalcogenide and different from the first semiconductor nanocrystal.

The semiconductor nanoparticle may include a zinc chalcogenide, wherein the zinc chalcogenide may include tellurium, and the semiconductor nanoparticle may emit blue light.

The semiconductor nanoparticle may have a core-shell structure that includes a core including the first semiconductor nanocrystal and a shell disposed on the core and including the second semiconductor nanocrystal.

The zinc oxide nanoparticle may exhibit an Al2p peak present in a range of binding energy of from about 72 electron volts (eV) to about 76 eV in an XPS analysis.

In the zinc oxide nanoparticle, an amount of aluminum may be greater than or equal to about 1 mol%, greater than or equal to about 2.7 mol% or greater than or equal to about 3.2 mol%, based on a total amount of zinc, magnesium, and aluminum. In the zinc oxide nanoparticle, an amount of aluminum may be less than or equal to about 29 mol%, or less than or equal to about 25 mol%, based on a total amount of zinc, magnesium, and aluminum.

In the zinc oxide nanoparticle, or the electron transport layer, a mole ratio of magnesium to zinc may be greater than or equal to about 0.1:1, or greater than or equal to about 0.12:1, and less than or equal to about 0.7:1, less than or equal to about 0.3:1, or less than or equal to about 0.25:1.

In the zinc oxide nanoparticle, or the electron transport layer, a mole ratio of aluminum to magnesium (Al:Mg) may be greater than or equal to about 0.1:1, or greater than or equal to about 0.2:1. In the zinc oxide nanoparticle, a mole ratio of aluminum to magnesium may be less than or equal to about 1.5:1, or less than or equal to about 1.2:1.

In the zinc oxide nanoparticle, or the electron transport layer, a mole ratio of aluminum to zinc (Al:Zn) may be greater than or equal to about 0.01:1, or greater than or equal to about 0.025:1. In the zinc oxide nanoparticle, a mole ratio of aluminum to zinc may be less than or equal to about 0.5:1, or less than or equal to about 0.3:1.

In the zinc oxide nanoparticle, or the electron transport layer, a mole ratio of a sum of aluminum and magnesium to zinc [(Al + Mg):Zn] may be greater than or equal to about 0.1:1 and less than or equal to about 1.5:1.

The electron transport layer may be disposed adjacent to the light-emitting layer (e.g., directly on the light-emitting layer). In an embodiment, the electron transport layer may contact the light-emitting layer.

In an X-ray diffraction analysis of the zinc oxide nanoparticle, a peak percentage defined by the following equation may be greater than or equal to about 1%, greater than or equal to about 1.5%, or greater than or equal to about 3%:

$$\text{Peak percentage (\%)} = [B/A] \times 100,$$

A: a maximum intensity of a peak present in a 2 theta range of from about 65 degrees to about 75 degrees, and
B: a maximum intensity of a peak present in a 2 theta range of from about 25 degrees to about 35 degrees.

The zinc oxide nanoparticle may further include an additional metal, the additional metal including an alkali metal, Ca, Zr, W, Ga, Ti, Y, or a combination thereof.

The alkali metal may include lithium, sodium, potassium, rubidium, cesium, or a combination thereof. The alkali metal may include potassium, cesium, rubidium, or a combination thereof.

The zinc oxide nanoparticle may further include an alkali metal, and a mole ratio of alkali metal to aluminum may be greater than or equal to about 0.1:1, greater than or equal to about 0.3:1, and less than or equal to about 1.5:1, or less than or equal to about 1:1.

The additional metal may include gallium (Ga).

The zinc oxide nanoparticle may further include a halogen. The halogen may include chlorine.

The zinc oxide nanoparticle may be dispersible in a C1 to C10 alcohol solvent. The zinc oxide nanoparticle may have a dispersibility in the C1 to C10 alcohol solvent to exhibit, as dispersed in the alcohol solvent and measured by a dynamic light scattering analysis, an average particle diameter measured by the dynamic light scattering analysis that is greater than or equal to about 4.5 nm, or greater than or equal to about 5 nm and less than or equal to about 500 nm..

The zinc oxide nanoparticle may have an organic amount of greater than or equal to about 25% by weight, or greater than or equal to about 26% by weight, based on a total weight of the zinc oxide nanoparticle, as analyzed by a thermogravimetric analysis.

In UV-Vis absorption spectroscopy analysis, the zinc oxide nanoparticle may have a first absorption peak wavelength in a range of greater than or equal to about 310 nm, or greater than or equal to about 315 nm and less than or equal to about 325 nm, or less than or equal to about 320 nm.

The zinc oxide nanoparticle may have a size or an average size of greater than or equal to about 1 nm, or greater than or equal to about 3 nm. The size or the average size of the zinc oxide nanoparticle may be less than or equal to about 14 nm, less than or equal to about 10 nm, less than or equal to about 8 nm, less than or equal to about 5 nm, or less than or equal to about 4 nm.

The zinc oxide nanoparticle may exhibit a unimodal (e.g., monodisperse) particle size distribution. The zinc oxide nanoparticle may exhibit a bimodal particle size distribution.

A thickness of the electron transport layer may be greater than or equal to about 5 nm. A thickness of the electron transport layer may be less than or equal to about 70 nm.

The electroluminescent device, or the light-emitting layer, may be configured to emit green light with application of a voltage. The electroluminescent device or the light-emitting layer may emit blue light with application of a voltage. The electroluminescent device or the light-emitting layer may emit red light with application of a voltage. The first light may be a green light, a blue light, or a red light.

The electroluminescent device has a maximum external quantum efficiency of greater than or equal to about 6%, greater than or equal to about 7%, greater than or equal to about 8%, greater than or equal to about 9%, greater than or equal to about 10%, greater than or equal to about 11%, greater than or equal to about 12%, greater than or equal to about 13%, or greater than or equal to about 14%. The maximum external quantum efficiency may be from about 6% to 50%, or from about 10% to about 40%.

The electroluminescent device may have a maximum luminance of greater than or equal to about 60,000 candela per square meter ($cd/m^2$), greater than or equal to about 70,000 $cd/m^2$, or greater than or equal to about 80,000 $cd/m^2$. The maximum luminance may be less than or equal to about 5,000,000 $cd/m^2$.

The electroluminescent device may exhibit a half-life (T50) of greater than or equal to about 90 hours, greater than or equal to about 100 hours, greater than or equal to about 150 hours, greater than or equal to about 240 hours, greater than or equal to about 300 hours, greater than or equal to about 400 hours, greater than or equal to about 500 hours, or greater than or equal to about 600 hours (e.g., as being measured at a predetermined initial luminance, e.g., an initial luminance of 650 nit). The T50 may be from about 150 hours to about 3000 hours, from about 250 hours to about 2000 hours, from about 300 hours to about 1000 hours, or any combination of the foregoing upper and lower limits.

The electroluminescent device may exhibit a T90 of greater than or equal to about 80 hours, greater than or equal to about 90 hours, or greater than or equal to about 100 hours (e.g., as being measured at a predetermined initial luminance, e.g., an initial luminance of 650 nit). The T90 may be less than or equal to about 800 hours, or less than or equal to about 300 hours.

When the T90 or T50 is measured, the electroluminescent device may exhibit an initial driving current value of less than or equal to about 0.1 mA and an initial driving voltage value of less than or equal to about 2.9 volts.

In an embodiment, a display device or an electronic apparatus may include the electroluminescent device.

The display device or an electronic apparatus may include (or may be) an augmented reality (AR) device, a (virtual reality) VR device, a handheld terminal (e.g., device), a monitor, a notebook computer, a television, an electronic display board, a camera, an electronic display component for an automatic vehicle, or an electric car.

An embodiment relates to a method for producing the aforementioned electroluminescent device. The method may include:

disposing (e.g., forming) the light-emitting layer on the first electrode;
applying a solution including the zinc oxide nanoparticles onto the light-emitting layer to form the electron transport layer; and
disposing (e.g., forming) the second electrode on the electron transport layer,
wherein the zinc oxide nanoparticle is prepared by a method including:

admixing a zinc precursor, a magnesium precursor, and aluminum precursor with a first solvent and a second solvent to obtain a first solution;
adding a base to the first solution to form the zinc oxide nanoparticle;
wherein a relative polarity difference between the first solvent and the second solvent is greater than or equal to about 0.3 and less than or equal to about 0.9.

The formed electron transport layer may be thermally treated.

A reaction between the precursors may be conducted by the addition of the base.

The method may further include adding a third solvent to the first solution after the addition of the base to facilitate precipitation of the zinc oxide nanoparticle.

In an embodiment, the obtaining of the first solution may include adding the zinc precursor, the magnesium precursor, and the aluminum precursor into the first solvent to dissolve the precursors and adding a second solvent to a resulting mixture.

In an embodiment, the obtaining of the first solution may include adding the zinc precursor, the magnesium precursor, and the aluminum precursor to a solvent mixture of the first solvent and the second solvent and dissolving the same.

The first solvent may be a C1 to C10 alcohol solvent.

The second solvent or the third solvent may include a C3 to C30 (e.g., C15) hydrocarbon solvent (e.g., a substituted or unsubstituted aliphatic hydrocarbon solvent, a substituted or unsubstituted aromatic hydrocarbon solvent, a substituted or unsubstituted alicyclic hydrocarbon solvent, or a solvent having a benzene ring in which one or more double bonds are hydrogenated), a C3 to C30 or C10 to C15 ester solvent (e.g., a C2 to C30 alkyl acetate solvent such as ethyl acetate), chloroform, a C2 to C30 ketone solvent (e.g., e.g., methyl ethyl ketone), a dioxane, or a combination thereof.

The second solvent and the third solvent may be the same or different.

The hydrocarbon solvent may include a halogen (e.g., chlorine) substituted hydrocarbon solvent.

The first solvent may be miscible with water or may have a solubility in water of greater than or equal to about 5 g/100 g.

The second solvent may have a solubility in water of less than or equal to about 1 g/100 g, less than or equal to about 0.1 g/100 g, or less than or equal to about 0.05 g/100 g.

A ratio between the first solvent and the second solvent (as a volume ratio, first solvent: second solvent) may be about 1:0.3 to about 1:3, or about 1:0.5 to about 1:2, or about 1:1.

The method may include stirring the first solution.

The stirring may be conducted at about 100 rpm or more, (e.g., about 300 rpm to about 700 rpm or about 400 rpm to about 500 rpm, or any combination of the foregoing upper and lower limits).

A temperature of the first solution may be greater than or equal to about 40 °C, or greater than or equal to about 50 °C. The temperature of the first solution may be less than or equal to about a boiling point of the first solvent (or the second solvent) or less than or equal to about 78 °C, less than or equal to about 70 °C, less than or equal to about 65 °C, or less than or equal to about 60 °C.

The base may include an inorganic base. The base may further include or may not include an organic base. The organic base may include an organic ammonium compound (for example, a quaternary ammonium salt compound including a C1 to C10 alkyl group).

The aluminum precursor may include an aluminum halide.

According to embodiments, an electroluminescent device capable of exhibiting improved life-span and electroluminescent characteristics at the same time is provided. The electroluminescent device of an embodiment may be driven with an improved light-emitting efficiency at a reduced current, and may exhibit an increased lifespan.

## BRIEF DESCRIPTION OF THE DRAWINGS

The above and other advantages and features of this disclosure will become more apparent by describing in further detail exemplary embodiments thereof with reference to the accompanying drawings, in which:

FIG. 1 is a schematic cross-sectional view of an exemplary embodiment of an electroluminescent device.

FIG. 2 is a schematic cross-sectional view of an exemplary embodiment of an electroluminescent device.

FIG. 3 is a schematic cross-sectional view of an exemplary embodiment of an electroluminescent device.

FIG. 4A shows an x-ray diffraction analysis result for a zinc oxide nanoparticle prepared in Preparation Example 1.

FIG. 4B shows an x-ray diffraction analysis result for a zinc oxide nanoparticle prepared in Preparation Example 4.

FIG. 5A shows an x-ray photoelectron spectroscopy analysis result for a zinc oxide nanoparticle prepared in Preparation Example 1, Preparation Example 2, and Comparative Preparation Example 2.

FIG. 5B shows an x-ray photoelectron spectroscopy analysis result for a zinc oxide nanoparticle prepared in Preparation Example 1, Preparation Example 2, and Comparative Preparation Example 2.

FIG. 5C shows an x-ray photoelectron spectroscopy analysis result for a zinc oxide nanoparticle prepared in Preparation Example 1, Preparation Example 2, and Comparative Preparation Example 2.

FIG. 6 is a graph of weight (percent, %) vs. temperature (°C) and derivative weight (deriv. weight) vs. temperature (°C), and shows the results of a thermogravimetric analysis (TGA) and derivative thermogravimetry (DTG) for the zinc oxide nanoparticles prepared in Preparation Examples 1 and 2 and Comparative Preparation Example 1.

## DETAILED DESCRIPTION OF THE EMBODIMENTS

Advantages and characteristics of this disclosure, and a method for achieving the same, will become evident referring to the following exemplary embodiments together with the drawings attached hereto. However, this invention may, be embodied in many different forms, the embodiments should not be construed as being limited to the embodiments set forth herein. Rather, these embodiments are provided so that this disclosure will be thorough and complete, and will fully convey the scope of the invention to those skilled in the art. Like reference numerals refer to like elements throughout.

In order to clearly explain the present disclosure, parts irrelevant to the description are omitted, and the same reference numerals are assigned to the same or similar elements throughout the specification. In the drawings, the thickness of layers, films, panels, regions, etc., are exaggerated for clarity. And in the drawings, for convenience of description, the thickness of some layers and regions are exaggerated. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

In addition, it will be understood that when an element such as a layer, film, region, or substrate is referred to as being "on" another element, it can be directly on the other element or intervening elements may also be present. In contrast, when an element is referred to as being "directly on" another element, there are no intervening elements present. Also, to be disposed "on" the reference portion means to be disposed above or below the reference portion and does not necessarily mean "above".

Furthermore, relative terms, such as "lower" or "bottom" and "upper" or "top," may be used herein to describe one element's relationship to another element as illustrated in the Figures. It will be understood that relative terms are intended to encompass different orientations of the device in addition to the orientation depicted in the Figures. For example, if the device in one of the figures is turned over, elements described as being on the "lower" side of other elements would then be oriented on "upper" sides of the other elements. The term "lower," can therefore, encompasses both an orientation of "lower" and "upper," depending on the particular orientation of the figure. Similarly, if the device in one of the figures is turned over, elements described as "below" or "beneath" other elements would then be oriented "above" the other elements. The terms "below" or "beneath" can, therefore, encompass both an orientation of above and below.

It will be understood that, although the terms "first," "second," "third," etc., may be used herein to describe various elements, components, regions, layers and/or sections, these elements, components, regions, layers and/or sections should not be limited by these terms. These terms are only used to distinguish one element, component, region, layer or section from another element, component, region, layer, or section. Thus, "a first element," "component," "region," "layer," or "section" discussed below could be termed a second element, component, region, layer, or section without departing from the teachings herein.

The terminology used herein is for the purpose of describing particular embodiments only and is not intended to be limiting. As used herein, the singular forms "a," "an," and "the" are intended to include the plural forms, including "at least one," unless the content clearly indicates otherwise. "At least one" is not to be construed as being limited to "a" or "an." "Or" means "and/or."

As used herein, the term "and/or" includes any and all combinations of one or more of the associated listed items. It will be further understood that the terms "comprises" and/or "comprising," or "includes" and/or "including" when used in this specification, specify the presence of stated features, regions, integers, steps, operations, elements, and/or components, but do not preclude the presence or addition of one or more other features, regions, integers, steps, operations, elements, components, and/or groups thereof.

As used herein, the term "cross-sectional" means a case in which a cross-section of a given object is cut, for example, in a substantially vertical direction and is viewed laterally.

Unless otherwise defined, all terms (including technical and scientific terms) used herein have the same meaning as commonly understood by one of ordinary skill in the art to which this disclosure belongs. It will be further understood that terms, such as those defined in commonly used, e.g., non-technical, dictionaries, should be interpreted as having a meaning that is consistent with their meaning in the context of the relevant art and the present disclosure, and will not be interpreted in an idealized or overly formal sense unless expressly so defined herein.

As used herein, values of a work function, a conduction band, or a lowest unoccupied molecular orbital (LUMO) (or valence band, or highest occupied molecular orbital (HOMO)) energy level is expressed as an absolute value from a vacuum level. In addition, when the work function or the energy level is referred to be "deep," "high" or "large," the work function or the energy level has a large absolute value based on "0 electron volts (eV)" of the vacuum level, while when the work function or the energy level is referred to be "shallow," "low," or "small," the work function or energy level has a small absolute value based on "0 eV" of the vacuum level. In an aspect, work function herein refers to a minimum energy required to remove an electron from e.g., a solid metal (e.g., a metal surface) to vacuum (e.g., immediately outside the solid surface).

As used herein, the term "first absorption peak" refers to a main excitonic peak appearing first from the longest wavelength region of a UV-vis absorption spectrum (i.e., appearing in the lowest energy region in the UV-Vis absorption spectrum), and the term "first absorption peak wavelength" or "wavelength of the first absorption peak" refers to the wavelength at which the first absorption peak reaches a maximum intensity.

As used herein, the average (value) may be mean or median. In an embodiment, the average (value) may be a mean value.

As used herein, the term "peak emission wavelength" is the wavelength at which a given emission spectrum of the light reaches its maximum.

As used herein, the term "Group" may refer to a group of Periodic Table.

As used herein, "Group I" refers to Group IA and Group IB, and examples may include Li, Na, K, Rb, and Cs, but are not limited thereto.

As used herein, "Group II" refers to Group IIA and Group IIB, and examples of Group II metal may be Cd, Zn, Hg, and Mg, but are not limited thereto.

As used herein, "Group III" refers to Group IIIA and Group IIIB, and examples of Group IIIA metal may be Al, In, Ga, and Tl, and examples of Group IIIB may be scandium, yttrium, or the like, but are not limited thereto.

As used herein, "Group IV" refers to Group IVA and Group IVB, and examples of a Group IVA metal may be Si, Ge, and Sn, and examples of Group IVB metal may be titanium, zirconium, hafnium, or the like, but are not limited thereto.

As used herein, "Group V" includes Group VA and includes nitrogen, phosphorus, arsenic, antimony, and bismuth, but is not limited thereto.

As used herein, "Group VI" includes Group VIA and includes sulfur, selenium, and tellurium, but is not limited thereto.

As used herein, "metal" includes a semi-metal such as Si.

As used herein, a number of carbon atoms in a group or a molecule may be referred to as a subscript (e.g., $C_{6-50}$) or as C6 to C50.

As used herein, when a definition is not otherwise provided, "substituted" refers to replacement of at least one hydrogen of a compound or a group with a corresponding substituent including a C1 to C30 alkyl group, a C2 to C30 alkenyl group, a C2 to C30 alkynyl group, a C6 to C30 aryl group, a C7 to C30 alkylaryl group, a C1 to C30 alkoxy group, a C1 to C30 heteroalkyl group, a C3 to C30 heterolaryl group, a C3 to C30 cycloalkyl group, a C3 to C15 cycloalkenyl group, a C6 to C30 cycloalkynyl group, a C2 to C30 heterocycloalkyl group, a halogen (-F, -Cl, -Br, or -I), a hydroxy group (-OH), a nitro group ($-NO_2$), a cyano group (-CN), an amino group (-NRR' wherein R and R' are each independently hydrogen or a C1 to C6 alkyl group), an azido group ($-N_3$), an amidino group ($-C(=NH)NH_2$), a hydrazino group ($-NHNH_2$), a hydrazono group ($=N(NH_2)$), an aldehyde group (-C(=O)H), a carbamoyl group ($-C(O)NH_2$), a thiol group (-SH), an ester group (-C(=O)OR, wherein R is a C1 to C6 alkyl group or a C6 to C12 aryl group), a carboxyl group (-COOH) or a salt thereof (-C(=O)OM, wherein M is an organic or inorganic cation), a sulfonic acid group ($-SO_3H$) or a salt thereof ($-SO_3M$, wherein M is an organic or inorganic cation), a phosphoric acid group ($-PO_3H_2$) or a salt thereof ($-PO_3MH$ or $-PO_3M_2$, wherein M is an organic or inorganic cation), or a combination thereof.

As used herein, when a definition is not otherwise provided, "hydrocarbon" or "hydrocarbon group" refers to a compound or a group including carbon and hydrogen (e.g., alkyl, alkenyl, alkynyl, or aryl group). The hydrocarbon group may be a monovalent group or a group having a valence of greater than one formed by removal of one or more hydrogen atoms from an alkane, an alkene, an alkyne, or an arene group. In the hydrocarbon or hydrocarbon group, at least one, methylene may be replaced by an oxide moiety, a carbonyl moiety, an ester moiety, -NH-, or a combination thereof. Unless otherwise stated to the contrary, the hydrocarbon or the hydrocarbon group (alkyl, alkenyl, alkynyl, or aryl) may have 1 to 60, 2 to 32, 3 to 24, or 4 to 12 carbon atoms.

As used herein, when a definition is not otherwise provided, "alkyl" refers to a linear or branched saturated monovalent hydrocarbon group (methyl, ethyl hexyl, etc.). In an embodiment, an alkyl group may have from 1 to 50 carbon atoms, or 1 to 18 carbon atoms, or 1 to 12 carbon atoms.

As used herein, when a definition is not otherwise provided, "alkenyl" refers to a linear or branched monovalent hydrocarbon group having a carbon-carbon double bond. In an embodiment, an alkenyl group may have from 2 to 50 carbon atoms, or 2 to 18 carbon atoms, or 2 to 12 carbon atoms.

As used herein, when a definition is not otherwise provided, "alkynyl" refers to a linear or branched monovalent hydrocarbon group having a carbon-carbon triple bond. In an embodiment, an alkenyl group may have from 2 to 50 carbon atoms, or 2 to 18 carbon atoms, or 2 to 12 carbon atoms.

As used herein, when a definition is not otherwise provided, "aryl" refers to a group having a carbocyclic aromatic system. When the aryl group includes a plurality of rings, the plurality of rings may be fused to each other. Examples include a phenyl group and a naphthyl group. In an embodiment, an aryl group may have 6 to 50 carbon atoms, or 6 to 18 carbon atoms, or 6 to 12 carbon atoms.

As used herein, when a definition is not otherwise provided, "hetero" refers to inclusion of 1 to 3 heteroatoms, e.g., N, O, P, Si, B, Se, Ge, Te, S, or a combination thereof.

As used herein, "heteroaryl" refers to an aromatic system having at least one N, O, P, Si, B, Se, Ge, Te, S, or a combination thereof as a ring forming atom. Examples of heteroaryl groups include a pyridinyl group, a pyrimidinyl group, a pyrazinyl group, a pyridazinyl group, a triazinyl group, a quinolinyl group, and an isoquinolinyl group. When the heteroaryl group includes a plurality of rings, the plurality of rings may be fused to each other. In an embodiment, the heteroaryl group may have 3 to 50 carbon atoms, or 6 to 18 carbon atoms, or 6 to 12 carbon atoms.

As used herein, when a definition is not otherwise provided, "alkoxy" refers to an alkyl group linked to oxygen (e.g., alkyl-O-) for example, a methoxy group, an ethoxy group, or a sec-butyloxy group.

The term "cycloalkyl group" as used herein refers to a monovalent monocyclic saturated hydrocarbon group. Examples thereof include a cyclopropyl group, a cyclobutyl group, a cyclopentyl group, a cyclohexyl group, and a cycloheptyl group. In an embodiment, the cycloalkyl group may have 3 to 50 carbon atoms, or 3 to 18 carbon atoms, or 3 to 12 carbon atoms.

The term "heterocycloalkyl group" as used herein refers to a monovalent monocyclic group including at least one N, O, P, Si, B, Se, Ge, Te, S, or a combination thereof as a ring-forming atom in addition to the carbon atoms that are ring-forming atoms. Examples thereof include a tetrahydrofuranyl group and a tetrahydrothiophenyl group. In an embodiment, the heterocycloalkyl group may have 2 to 50 carbon atoms, or 2 to 18 carbon atoms, or 2 to 12 carbon atoms.

The term "cycloalkenyl group" as used herein refers to a monovalent monocyclic hydrocarbon group that has at least one carbon-carbon double bond in its ring, wherein the molecular structure as a whole is non-aromatic. Examples thereof include a cyclopentenyl group, a cyclohexenyl group, and a cycloheptenyl group. In an embodiment, the cycloalkenyl group may have 3 to 50 carbon atoms, or 3 to 18 carbon atoms, or 3 to 12 carbon atoms.

The term "heterocycloalkenyl group" as used herein refers to a monovalent monocyclic group including at least one N, O, P, Si, B, Se, Ge, Te, S, or a combination thereof as a ring-forming atom, and at least one double bond in its ring. Examples of the heterocycloalkenyl group include a 2,3-dihydrofuranyl group and a 2,3-dihydrothiophenyl group. In an embodiment, the heterocycloalkenyl group may have 2 to 50 carbon atoms, or 2 to 18 carbon atoms, or 2 to 12 carbon atoms.

The term "arylalkyl group" refers to an alkyl group substituted with an aryl group. An example of an arylalkyl group is a benzyl group (i.e., $CH_2$-phenyl).

The term "alkylaryl group" refers to an aryl group substituted with an alkyl group. An example of an alkylaryl group is a toluyl group.

As used herein, when a definition is not otherwise provided, "amine" is a compound represented by $NR_3$, wherein each R is independently hydrogen, a C1-C12 alkyl group, a C7-C20 alkylaryl group, a C7-C20 arylalkyl group, or a C6-C18 aryl group.

As used herein, the expression "not including cadmium (or other harmful heavy metal)" means that a concentration of cadmium (or another heavy metal deemed harmful) may be less than or equal to about 100 parts per million by weight (ppmw), less than or equal to about 50 ppmw, less than or equal to about 10 ppmw, less than or equal to about 1 ppmw, less than or equal to about 0.1 ppmw, less than or equal to about 0.01 ppmw, or zero. In an embodiment, substantially no amount of cadmium (or other toxic heavy metal) may be present or, if present, an amount of cadmium (or other heavy metal) may be less than or equal to a detection limit or as an impurity level of a given analysis tool (e.g., an inductively coupled plasma atomic emission spectroscopy instrument).

Unless mentioned to the contrary, a numerical range recited herein is inclusive. Unless mentioned to the contrary, a numerical range recited herein includes any real number within the endpoints of the stated range and includes the endpoints thereof. In this specification, a numerical endpoint or an upper or lower limit value (e.g., recited either as a "greater than or equal to value" "at least value" or a "less than or equal to value" or recited with "from" or "to") may be used to form a numerical range of a given feature. In other words, the upper and lower endpoints set forth for various numerical values may be independently combined to provide a range.

"About" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ±10%, 5%, 3%, or 1% of the stated value.

As used herein, a nanoparticle is a structure having at least one region or characteristic dimension with a nanoscale dimension. In an embodiment, a dimension (or an average dimension) of the nanostructure is less than or equal to about 500 nanometers (nm), less than or equal to about 300 nm, less than or equal to about 250 nm, less than or equal to about 150 nm, less than or equal to about 100 nm, less than or equal to about 50 nm, or less than or equal to about 30 nm, and may be greater than about 0.1 nm or greater than about 1 nm. In an embodiment, the nanoparticle may have any suitable shape. The nanoparticle (e.g., a semiconductor nanoparticle or a metal oxide nanoparticle) may include a nanowire, a nanorod, a nanotube, a branched nanostructure, a nanotetrapod, a nanotripod, a nanobipod, a nanocrystal, a nanodot, a multi-pod type shape such as at least two pods, or the like and is not limited thereto. The nanoparticle can be, e.g., substantially crystalline, substantially monocrystalline, polycrystalline, (for example, at least partially) amorphous, or a combination thereof.

In an embodiment, a semiconductor nanoparticle such as a quantum dot may exhibit quantum confinement or exciton confinement. As used herein, the term "quantum dot" or "semiconductor nanostructure" is not limited in a shape thereof unless otherwise defined. A semiconductor nanoparticle or a quantum dot may have a size smaller than a Bohr excitation diameter for a bulk crystal material having an identical composition and may exhibit a quantum confinement effect. The semiconductor nanoparticle or the quantum dot may emit light corresponding to a bandgap energy thereof by controlling a size of a nanocrystal acting as an emission center.

As used herein, the term "T50" is a time (hours, hr) the brightness (e.g., luminance) of a given device decreases to 50% of the initial brightness (100%) as, e.g., when, the given device is started to be driven, e.g., operated, at a predetermined initial brightness (e.g., 650 nit).

As used herein, the term "T90" is a time (hr) the brightness (e.g., luminance) of a given device decreases to 90% of the initial brightness (100%) as the given device is started to be driven at a predetermined initial brightness (e.g.,

650 nit).

As used herein, the phrase "external quantum efficiency (EQE)" is a ratio of the number of photons emitted from a light-emitting diode (LED) to the number of electrons passing through the device and can be a measurement as to how efficiently a given device converts electrons to photons and allows the photons to escape. The EQE may be determined by the following equation:

$$EQE = \text{(efficiency of injection)} \times \text{((solid-state) quantum yield)} \times \text{(efficiency of extraction)}$$

wherein the efficiency of injection is a proportion of electrons passing through the device that are injected into the active region, the quantum yield is a proportion of all electron-hole recombinations in the active region that are radiative and produce photons, and the efficiency of extraction is a proportion of photons generated in the active region that escape from the given device.

As used herein, a maximum EQE is a greatest value of the EQE.

As used herein, a maximum luminance is the highest value of luminance for a given device.

As used herein, the phrase, quantum efficiency, may be used interchangeably with the phrase, quantum yield. In an embodiment, the quantum efficiency may be a relative quantum yield or an absolute quantum yield, for example, which can be readily measured by any suitable, e.g., commercially available, equipment. The quantum efficiency (or quantum yield) may be measured in a solution state or a solid state (in a composite). In an embodiment, "quantum yield (or quantum efficiency)" may be a ratio of photons emitted to photons absorbed, e.g., by a nanostructure or population of nanostructures. In an embodiment, the quantum efficiency may be determined by any suitable method. For example, there may be two methods for measuring the fluorescence quantum yield or efficiency: the absolute method and the relative method.

The absolute method directly obtains the quantum yield by detecting all sample fluorescence through the use of an integrating sphere. In the relative method, the fluorescence intensity of a standard sample (e.g., a standard dye) may be compared with the fluorescence intensity of an unknown sample to calculate the quantum yield of the unknown sample. Coumarin 153, Coumarin 545, Rhodamine 101 inner salt, Anthracene, and Rhodamine 6G may be used as standard dye, depending on the photoluminescence (PL) wavelengths thereof, but are not limited thereto.

A bandgap energy of a semiconductor nanoparticle may vary with a size and a composition of a nanocrystal. For example, as a size of the semiconductor nanoparticle increases, the bandgap energy of the semiconductor nanoparticle may become smaller, e.g., narrower, and the semiconductor nanoparticle may emit light having an increased wavelength. A semiconductor nanocrystal may be used as a light-emitting material in various fields such as in, a display device, an energy device, or a bio light-emitting device.

A semiconductor nanoparticle based electroluminescent device (hereinafter, also referred to as a QD-LED) may emit light by applying a voltage and includes a semiconductor nanoparticle or a quantum dot as a light-emitting material. The QD-LED is different from an organic light-emitting diode (OLED) in light of a specific emission principle and may exhibit light emission with more desirable optical properties, e.g., higher purity, improved colors (e.g., red, green, and blue), and improved color reproducibility and may draw attention as a material for a next generation display device. A method of producing the QD-LED may include a solution process, which may reduce manufacturing costs. In addition, a semiconductor nanoparticle in the QD-LED may be based on an inorganic material, contributing to realization of increased display (light emission) stability over time. However, it is still desirable to develop a technology that can further improve device properties and lifespan characteristics for the QD-LED.

In an embodiment, a structure of the QD-LED includes a light-emitting layer (EML) disposed between two electrodes (e.g., an anode and a cathode), and one or more auxiliary layers (e.g., a hole transport layer (HTL) and electron transport layer (ETL)) provided on opposite surfaces of the light-emitting layer, providing a charge balance and assisting an operation of a device. A QD-LED according to an embodiment may include an organic or inorganic hole auxiliary layer (e.g., organic or inorganic hole transport layer), for example, a p-type conductive organic material including poly(3,4-ethylenedioxythiophene): polystyrene sulfonate (PEDOT:PSS), poly(4-butylphenyl-diphenyl-amine) (TPD), poly(vinylcarbazole) (PVK), poly[(9,9-dioctylfluoren-2,7-diyl)-co-(4,4'-(N-(4-sec-butylphenyl))diphenylamine]] (TFB), or a combination thereof, or an inorganic hole transporter such as NiO or CuO. A QD-LED according to an embodiment may include an inorganic material (e.g., a zinc oxide) in an electron auxiliary layer such as an electron transport layer (ETL). In the QD-LED of an embodiment, an electron auxiliary layer containing the inorganic material on the quantum dot-based light-emitting layer EML may be easily formed through a solution process, for example, a low-temperature process, and the electron auxiliary layer may provide improved mobility of electrons. A hole injected from the anode and an electron injected from the cathode may be supplied to the light-emitting layer through the auxiliary layers and an exciton may be formed and light may be emitted therefrom.

A QD-LED according to an embodiment may include an inorganic material (e.g., a zinc oxide) in an electron auxiliary layer such as an electron transport layer (ETL). In the QD-LED of an embodiment, the electron auxiliary layer containing the inorganic material on the light-emitting layer may be readily formed through a solution process, for example, a relatively low-temperature (e.g., room temperature) process, and the electron auxiliary layer may provide improved mobility of electrons. A hole injected from the anode and an electron injected from the cathode may be supplied to the light-emitting layer through the auxiliary layers and an exciton may be formed and light may be emitted therefrom.

In the light-emitting layer, a quantum dot capable of exhibiting a practically applicable level of an electroluminescent property may include a harmful heavy metal such as cadmium (Cd), lead, mercury, or a combination thereof. Accordingly, it is desirable to provide a light-emitting device or a display device having a light-emitting layer substantially free of the harmful heavy metal. In conventional QD-LEDs, currently reported and satisfactory electroluminescent properties are mostly based on a cadmium-based (i.e., cadmium-containing) LED, and there is room for improvement in a QD-LED device using an environmentally-friendly quantum dot and for example emitting blue light that does not include cadmium or other harmful heavy metals.

In an embodiment of a QD-LED device, a zinc oxide nanoparticle prepared by the method of an embodiment and having the features described herein may be included in the electronic auxiliary layer, and accordingly, the QD-LED including a cadmium free semiconductor nanoparticle in a light-emitting layer may exhibit a desired level of an electroluminescent property and an increased lifespan.

In an embodiment, an electroluminescent device may emit a desired light by applying a voltage, for example, with or without a separate light source.

The electroluminescent device in accordance with an exemplary embodiment includes zinc oxide nanoparticles including magnesium and aluminum in an electron transport layer, and may exhibit an extended life with improved electroluminescent properties.

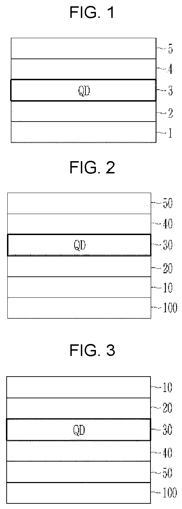

In an embodiment, an electroluminescent device includes a first electrode 1 and a second electrode 5 spaced apart from each other (e.g., each having a surface opposite the other, i.e., each with a surface facing each other); a light-emitting layer 3 disposed between the first electrode 1 and the second electrode 5 and including a semiconductor nanoparticle, and an electron transport layer 4 disposed between the light-emitting layer 3 and the second electrode 5 and including a zinc oxide nanoparticle. In an embodiment, the electroluminescent device may further include a hole auxiliary layer 2 between the light-emitting layer and the first electrode. The hole auxiliary layer may include a hole transport layer, a hole injection layer, or a combination thereof. The hole auxiliary layer may include an organic compound (see FIG. 1, FIG. 2, and FIG. 3).

In an embodiment, the first electrode or the second electrode may include an anode or a cathode. The first electrode may include an anode, and the second electrode may include a cathode. The first electrode may include a cathode and the second electrode may include an anode. In an embodiment, the second electrode includes a cathode. In the electroluminescent device of an embodiment, the first electrode 10 or the second electrode 50 may be disposed on a (transparent) substrate 100. The transparent substrate may be a light extraction surface (see, e.g., FIG. 2 and FIG. 3). The light-emitting layer may be disposed in a pixel (or a subpixel) of a display device described herein.

Referring to FIGS. 2 and 3, in an electroluminescent device of an embodiment, a light-emitting layer 30 may be disposed between a first electrode (e.g., anode) 10 and a second electrode (e.g., cathode) 50. The cathode 50 may include an electron injection conductor. The anode 10 may include a hole injection conductor. A work function of each of the electron or hole injection conductors included in the cathode and the anode may be appropriately adjusted and are not particularly limited. For example, the cathode may have a small work function and the anode may have a relatively large work function, or vice versa.

The electron or hole injection conductors may include a metal-based (i.e., metal-containing) material (e.g., a metal, a metal compound, an alloy, or a combination thereof) such as aluminum, magnesium, tungsten, nickel, cobalt, platinum, palladium, calcium, LiF, etc.; a metal oxide such as gallium indium oxide or indium tin oxide (ITO); or a conductive polymer (e.g., having a relatively high work function) such as polyethylene dioxythiophene, but are not limited thereto.

The first electrode, the second electrode, or a combination thereof may be a light-transmitting electrode or a transparent electrode. In an embodiment, both the first electrode and the second electrode may be a light-transmitting electrode. The first electrode, the second electrode, or a combination thereof may each be a patterned electrode.

The first electrode, the second electrode, or a combination thereof may be disposed on a (e.g., insulating) substrate 100. The substrate 100 may be optically transparent (e.g., may have a light transmittance of greater than or equal to about 50%, greater than or equal to about 60%, greater than or equal to about 70%, greater than or equal to about 80%, greater than or equal to about 85%, or greater than or equal to about 90% and, for example, less than or equal to about 99%, or less than or equal to about 95%). The substrate may have a transmittance of greater than or equal to about 50%, greater than or equal to about 60%, greater than or equal to about 70%, greater than or equal to about 80%, or greater than or equal to about 90% for light emitted from semiconductor nanoparticles that are described herein. The substrate 100 may include a region for a blue pixel, a region for a red pixel, a region for a green pixel, or a combination thereof. In an embodiment, a thin film (e.g., film) transistor may be disposed in each region of the substrate, but it is not limited thereto. In an embodiment, a source electrode or a drain electrode of the thin film transistor may be electrically connected to the first electrode or the second electrode.

The substrate 100 may be a rigid or a flexible substrate. The substrate 100 may be a substrate including an insulating material. The substrate may include glass; various polymers such as a polyester of polyethylene terephthalate (PET), polyethylene naphthalate (PEN), and the like, polycarbonate, and polyacrylate; a polysiloxane (e.g., polydimethylsiloxane (PDMS)); an inorganic material such as $Al_2O_3$ or ZnO; or a combination thereof but is not limited thereto. A thickness of the substrate may be appropriately selected taking into consideration a substrate material but is not particularly limited. In an embodiment, the light-transmitting electrode may be disposed on a (e.g., insulating) transparent substrate.

The electrode may include, for example, a transparent conductor such as an indium tin oxide (ITO) or an indium zinc oxide (IZO), a gallium indium tin oxide, a zinc indium tin oxide, a titanium nitride, a polyaniline, a LiF/Mg:Ag, and the like; or a metal thin film of a single layer or a plurality of layers, but it is not limited thereto. In an embodiment, one of the first electrode or the second electrode may include aluminum (Al), a lithium-aluminum (Li:Al) alloy, a magnesium-silver (Mg:Ag) alloy, or lithium fluoride-aluminum (LiF:Al) alloy. The first electrode or the second electrode may be or may include an opaque electrode.

The thickness of each electrode (the first electrode, the second electrode, or both) is not particularly limited and may be appropriately selected taking into consideration device efficiency. For example, the thickness of the electrode may be greater than or equal to about 5 nm, greater than or equal to about 10 nm, greater than or equal to about 20 nm, greater than or equal to about 30 nm, greater than or equal to about 40 nm, or greater than or equal to about 50 nm. For example, the thickness of the electrode may be less than or equal to about 100 micrometers ($\mu$m), less than or equal to about 90 $\mu$m, less than or equal to about 80 $\mu$m, less than or equal to about 70 $\mu$m, less than or equal to about 60 $\mu$m, less than or equal to about 50 $\mu$m, less than or equal to about 40 $\mu$m, less than or equal to about 30 $\mu$m, less than or equal to about 20 $\mu$m, less than or equal to about 10 $\mu$m, less than or equal to about 1 $\mu$m, less than or equal to about 900 nm, less than or equal to about 500 nm, or less than or equal to about 100 nm.

The method of forming the electrode is not particularly limited, and can be appropriately selected taking into consideration an electrode material. In one implementation, the electrode can be formed by deposition, coating, or a combination thereof, but is not limited thereto.

The light-emitting layer 3, or 30, may be disposed between the first electrode 1 and the second electrode 5 (e.g., the anode 10 and the cathode 50). The light-emitting layer may include a semiconductor nanoparticle (e.g., a plurality of semiconductor nanoparticles) such as a blue light-emitting nanoparticle, a red light-emitting nanoparticle, or a green light-emitting nanoparticle. The light-emitting layer may include one or more (e.g., 2 or more, or 3 or more, and 10 or less) monolayers of the semiconductor nanoparticle.

The light-emitting layer may be patterned (not shown). In an embodiment, the patterned light-emitting layer may include a blue light-emitting layer disposed in the blue pixel. In an embodiment, the light-emitting layer may further include a red light-emitting layer disposed in the red pixel or a green light-emitting layer disposed in the green pixel. In an embodiment, the light-emitting layer may include a red light-emitting layer disposed in the red pixel and a green light-emitting layer disposed in the green pixel. Each of the (e.g., red, green, or blue) light-emitting layers may be (e.g., optically) separated from an adjacent light-emitting layer by a partition wall. In an embodiment, partition walls such as black matrices may be disposed between the red light-emitting layer, the green light-emitting layer, and the blue light-emitting layer. The red light-emitting layer, the green light-emitting layer, and the blue light-emitting layer may be optically isolated from each other.

In an embodiment, the light-emitting layer 3, 30, or the semiconductor nanoparticle may not include cadmium. In an embodiment, the light-emitting layer 3, 30, or the semiconductor nanoparticle may not include mercury, lead, or a combination thereof.

In an embodiment, the semiconductor nanoparticle may have a core-shell structure. In an embodiment, the semiconductor nanoparticle or the core-shell structure may include a core including a first semiconductor nanocrystal and a shell disposed on the core and including a second semiconductor nanocrystal having a composition different from that of the first semiconductor nanocrystal.

The semiconductor nanoparticle (or the first semiconductor nanocrystal, the second semiconductor nanocrystal, or a combination thereof) may include a Group II-VI compound, a Group III-V compound, a Group IV-VI compound, a Group IV element or compound, a Group I-III-VI compound, a Group II-III-VI compound, a Group I-II-IV-VI compound, or a combination thereof. In an embodiment, the light-emitting layer or the semiconductor nanoparticle (e.g., the first semiconductor nanocrystal, or the second semiconductor nanocrystal) may not include cadmium. In an embodiment, the light-emitting layer, or the semiconductor nanoparticle (e.g., the first semiconductor nanocrystal or the second semiconductor nanocrystal) may not include lead. In an embodiment, the light-emitting layer, or the semiconductor nanoparticle (e.g., the first semiconductor nanocrystal, or the second semiconductor nanocrystal) may not include a combination of lead and cadmium.

The Group II-VI compound may include a binary element compound such as ZnS, ZnSe, ZnTe, ZnO, HgS, HgSe, HgTe, MgSe, MgS, or a combination thereof; a ternary element compound such as ZnSeS, ZnSeTe, ZnSTe, HgSeS, HgSeTe, HgSTe, HgZnS, HgZnSe, HgZnTe, MgZnSe, MgZnS, or a combination thereof; a quaternary element compound such as HgZnTeS, HgZnSeS, HgZnSeTe, HgZnSTe, or a combination thereof; or a combination thereof. The Group II-VI compound may further include a Group III metal.

The Group III-V compound may include a binary element compound such as GaN, GaP, GaAs, GaSb, AlN, AlP, AlAs, AlSb, InN, InP, InAs, InSb, or a combination thereof; a ternary element compound such as GaNP, GaNAs, GaNSb, GaPAs, GaPSb, AlNP, AlNAs, AlNSb, AlPAs, AlPSb, InNP, InNAs, InNSb, InPAs, InPSb, or a combination thereof; a quaternary element compound such as GaAlNP, GaAlNAs, GaAlNSb, GaAlPAs, GaAlPSb, GaInNP, GaInNAs, GaInNSb, GaInPAs, GaInPSb, InAlNP, InAlNAs, InAlNSb, InAlPAs, InAlPSb, or a combination thereof; or a combination thereof. The Group III-V compound may further include a Group II metal (e.g., InZnP).

The Group IV-VI compound may include a binary element compound such as SnS, SnSe, SnTe, PbS, PbSe, PbTe, or a combination thereof; a ternary element compound such as SnSeS, SnSeTe, SnSTe, PbSeS, PbSeTe, PbSTe, SnPbS, SnPbSe, SnPbTe, or a combination thereof; a quaternary element compound such as SnPbSSe, SnPbSeTe, SnPbSTe, or a combination thereof; or a combination thereof.

Examples of the Group I-III-VI compound may include $CuInSe_2$, $CuInS_2$, CuInGaSe, and CuInGaS, but are not limited thereto. Examples of the Group I-III-VI compound may include a ternary element compound such as AgInS, $AgInS_2$, $AgInSe_2$, AgGaS, $AgGaS_2$, $AgGaSe_2$, CuInS, $CuInS_2$, $CuInSe_2$, $CuGaS_2$, $CuGaSe_2$, $CuGaO_2$, $AgGaO_2$, $AgAlO_2$ or a combination thereof; a quaternary element compound such as $AgInGaS_2$, $AgInGaSe_2$; or a combination thereof.

Examples of the Group I-II-IV-VI compound may be CuZnSnSe, and CuZnSnS, but are not limited thereto.

The Group IV element or compound may include a single element such as Si, Ge, or a combination thereof; a binary element compound such as SiC, SiGe, or a combination thereof; or a combination thereof.

Each element included in a multi-element compound such as a binary element compound, a ternary element compound, or a quaternary element compound may be present in the particle at a uniform concentration or at a non-uniform concentration. For example, the chemical formula described above means the types of elements included in the compound, and the ratio among the elements in the compound may be different. For example, the chemical formula "$AgInGaS_2$" may include $AgIn_xGa_{1-x}S_2$ (x is a real number of greater than 0 to less than 1), but is not limited thereto.

In an embodiment, the first semiconductor nanocrystal may include a metal including indium, zinc, or a combination thereof, and a non-metal including phosphorus, selenium, tellurium, sulfur, or a combination thereof. In an embodiment, the second semiconductor nanocrystal may include a metal including indium, zinc, or a combination thereof, and a non-metal element including phosphorus, selenium, tellurium, sulfur, or a combination thereof.

In an embodiment, the first semiconductor nanocrystal may include InP, InZnP, ZnSe, ZnSeS, ZnSeTe, or a combination thereof; the second semiconductor nanocrystal may include ZnSe, ZnSeS, ZnS, ZnTeSe, or a combination thereof. In an embodiment, the shell may include zinc, sulfur, and optionally selenium for example in the outermost layer.

In an embodiment, the semiconductor nanoparticle may emit blue or green light and may include a core including ZnSeTe, ZnSe, or a combination thereof, and a shell including a zinc chalcogenide (e.g., ZnS, ZnSe, ZnSeS, or a combination thereof). An amount of sulfur in the shell may increase or decrease in a radial direction (from the core toward the surface), e.g., the amount of sulfur may have a concentration gradient wherein the concentration of sulfur varies radially (e.g., decreases or increases in a direction toward the core).

In an embodiment, the semiconductor nanoparticle may emit red or green light, the core may include InP, InZnP, or a combination thereof, and the shell may include a Group II metal including zinc and a non-metal including sulfur, selenium, or a combination thereof.

In an embodiment, the semiconductor nanoparticle may have a core-shell structure, and on the interface between the core and the shell, an alloyed interlayer may be present or may not be present. The alloyed interlayer layer may include a homogeneous alloy or may have a concentration gradient. The gradient alloy may have a concentration gradient wherein the concentration of an element of the shell varies radially (e.g., decreases or increases in a direction toward the core).

In an embodiment, the shell may have a composition that varies in a radial direction. In an embodiment, the shell may be a multilayered shell including two or more layers. In a multilayered shell, adjacent two layers may have different compositions from each other. In a multilayered shell, a, e.g., at least one, layer may independently include a semiconductor nanocrystal having a single composition. In a multilayered shell, a, e.g., at least one, layer may independently have an alloyed semiconductor nanocrystal. In a multilayered shell, a, e.g., at least one, layer may have a concentration gradient that varies radially in terms of a composition of a semiconductor nanocrystal.

In an embodiment, in the semiconductor nanoparticle having a core-shell structure, a shell material may have a bandgap energy that is greater than that of the core. The materials of the shell may have a bandgap energy that is less than that of the core. In the case of a multilayered shell, the bandgap energy of the outermost layer material of the shell may be greater than the bandgap energies of the core and the inner layer material of the shell (layers that are closer to the core). In the case of a multilayered shell, a semiconductor nanocrystal of each layer is selected to have an appropriate bandgap, thereby effectively exhibiting a quantum confinement effect.

The semiconductor nanoparticle according to an embodiment may include, for example, an organic ligand which is bonded or coordinated to a surface thereof.

An absorption or emission wavelength of the semiconductor nanoparticle may be controlled by adjusting the compositions, the particle size, or a combination thereof, of the semiconductor nanoparticle. The semiconductor nanoparticle included in the light-emitting layer 3, or 30, may emit light of a desired color. The semiconductor nanoparticle may include a blue light-emitting semiconductor nanoparticle, a green light-emitting semiconductor nanoparticle, or a red light-emitting semiconductor nanoparticle. In an embodiment, the light emitting layer may be configured to emit blue light, green light, or red light, and wavelengths of blue light, green light, and red light are as described herein.

In an embodiment, a peak emission wavelength of the semiconductor nanoparticle or a light emission layer (or the light emitted from the electroluminescent device) may be in a wavelength range from ultraviolet to infrared. In an embodiment, the peak emission wavelength of the semiconductor nanoparticle or the light-emitting layer (or the light emitted from the electroluminescent device) may be greater than or equal to about 300 nm, greater than or equal to about 500 nm, greater than or equal to about 510 nm, greater than or equal to about 520 nm, greater than or equal to about 530 nm, greater than or equal to about 540 nm, greater than or equal to about 550 nm, greater than or equal to about 560 nm, greater than or equal to about 570 nm, greater than or equal to about 580 nm, greater than or equal to about 590 nm, greater than or equal to about 600 nm, or greater than or equal to about 610 nm. The peak emission wavelength may be less than or equal to about 900 nm, less than or equal to about 800 nm, less than or equal to about 650 nm, less than or equal to about 640 nm, less than or equal to about 630 nm, less than or equal to about 620 nm, less than or equal to about 610 nm, less than or equal to about 600 nm, less than or equal to about 590 nm, less than or equal to about 580 nm, less than or equal to about 570 nm, less than or equal to about 560 nm, less than or equal to about 550 nm, or less than or equal to about 540 nm. The peak emission wavelength may be from about 500 nm to about 650 nm.

The semiconductor nanoparticle, the light-emitting layer, or the electroluminescent device may emit green light (for example, on an application of a voltage or irradiation with light) and a peak emission wavelength thereof may be in the range of greater than or equal to about 500 nm (for example, greater than or equal to about 510 nm, or greater than or equal to about 515 nm) and less than or equal to about 560 nm, for example, less than or equal to about 540 nm, or less than or equal to about 530 nm.

The semiconductor nanoparticle, the light-emitting layer, or the electroluminescent device may emit red light (for example, on an application of voltage or irradiation with light), and a peak emission wavelength thereof may be in the range of greater than or equal to about 600 nm, for example, greater than or equal to about 610 nm and less than or equal to about 650 nm, or less than or equal to about 640 nm.

The semiconductor nanoparticle, the light-emitting layer, or the electroluminescent device may emit blue light (for example, on an application of voltage or irradiation with light), and a peak emission wavelength thereof may be greater than or equal to about 430 nm (for example, greater than or equal to about 450 nm, greater than or equal to about 455 nm, greater than or equal to about 460 nm, greater than or equal to about 465 nm) and less than or equal to about 480 nm (for example, less than or equal to about 475 nm, less than or equal to about 470 nm, or less than or equal to about 465 nm).

In an embodiment, the semiconductor nanoparticle, the light-emitting layer, or the electroluminescent device may exhibit a luminescent spectrum (e.g., photo- or electro- luminescent spectrum) with a relatively narrow full width at half maximum. In an embodiment, in the photo- or electro- luminescent spectrum, the semiconductor nanoparticle, the light-emitting layer, or the electroluminescent device may exhibit a full width at half maximum of less than or equal to about 45 nm, less than or equal to about 44 nm, less than or equal to about 43 nm, less than or equal to about 42 nm, less than or equal to about 41 nm, less than or equal to about 40 nm, less than or equal to about 39 nm, less than or equal to about 38 nm, less than or equal to about 37 nm, less than or equal to about 36 nm, or less than or equal to about 35 nm. The full width at half maximum may be greater than or equal to about 10 nm, greater than or equal to about 15 nm, greater than or equal to about 20 nm, or greater than or equal to about 25 nm.

The semiconductor nanoparticle may exhibit a quantum efficiency (or quantum yield) of greater than or equal to about 10%, for example, greater than or equal to about 30%, greater than or equal to about 50%, greater than or equal to about 60%, greater than or equal to about 70%, greater than or equal to about 80%, greater than or equal to about 90%, or about 100%.

The semiconductor nanoparticle may have a size (or an average size, hereinafter, can be simply referred to as "size") of greater than or equal to about 1 nm and less than or equal to about 100 nm. The size may be a diameter or equivalent diameter converted by assuming a spherical shape from an electron microscope image when not spherical. The size may be calculated from a result of an inductively coupled plasma atomic emission spectroscopy (ICP-AES) analysis. In an embodiment, the semiconductor nanoparticle may have a size of from about 1 nm to about 50 nm, for example, from about 2 nm (or about 3 nm) to about 35 nm. In an embodiment, a size (or an average size) of the semiconductor nanoparticle may be greater than or equal to about 3 nm, greater than or equal to about 4 nm, greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, or greater than or equal to about 12 nm. In an embodiment, a size (or an average size) of the semiconductor nanoparticle may be less than or equal to about 50 nm, less than or equal to about 40 nm, less than or equal to about 30 nm, less than or equal to about 25 nm, less than or equal to about 20 nm, less than or equal to about 19 nm, less than or equal to about 18 nm, less than or equal to about 17 nm, less than or equal to about 16 nm, less than or equal to about 15 nm, less than or equal to about 14 nm, less than or equal to about 13 nm, or less than or equal to about 12 nm.

A shape of the semiconductor nanoparticle or the semiconductor nanostructure is not particularly limited. For example, the shape of the semiconductor nanoparticle may include, but is not limited to, a sphere, a polyhedron, a pyramid, a multi-pod shape, a hexahedron, a cube, a cuboid, a nanotube, a nanorod, a nanowire, or a nanosheet.

The semiconductor nanoparticle may be prepared using an appropriate method. The semiconductor nanoparticle may be prepared for example by a chemical wet method wherein a nanocrystal particle may grow by a reaction between precursors in a reaction system including an organic solvent and an organic ligand. The organic ligand or the organic solvent may coordinate (with or to) a surface of the semiconductor nanocrystal to control the growth thereof.

In an embodiment, for example, the method for preparing the semiconductor nanoparticle having a core/shell structure may include obtaining the core; preparing a first shell precursor solution including a first shell precursor containing a metal (e.g., zinc) and optionally an organic ligand; preparing a second shell precursor containing a non-metal element (e.g., sulfur, selenium, or a combination thereof); and heating the first shell precursor solution to a reaction temperature (e.g., greater than or equal to about 180 °C, greater than or equal to about 200 °C, greater than or equal to about 240 °C, or greater than or equal to about 280 °C to less than or equal to about 360 °C, less than or equal to about 340 °C, or less than or equal to about 320 °C) and adding the core and the second shell precursor (e.g., once or more, or twice or more) to form a shell of a second semiconductor nanocrystal on the first semiconductor nanocrystal core. The method may further include separating the core from a reaction system used for its preparation and dispersing it in an organic solvent to prepare a core dispersion.

In an embodiment, for a shell formation, a solvent and optionally a ligand compound may be heated (or vacuum-treated) under vacuum to a predetermined temperature (e.g., 100 °C or higher), and thereafter, may be heated to a predetermined temperature (e.g., 120 °C or higher) after introducing nitrogen (inert atmosphere) into the reaction flask. Subsequently, the core may be added to the flask, and the shell precursors are sequentially or simultaneously added, and the reaction flask may be heated at a predetermined reaction temperature. One or more shell precursors may be sequentially introduced in different proportions of the mixture during the reaction time to provide a desired compositional gradient of the shell layer.

In the semiconductor nanoparticle of an embodiment, the core may be prepared by an appropriate method. The organic solvent may include a C6 to C22 primary amine such as a hexadecylamine, a C6 to C22 secondary amine such as dioctylamine, a C6 to C40 tertiary amine such as a trioctyl amine, a nitrogen-containing heterocyclic compound such as pyridine, a C6 to C40 olefin such as octadecene, a C6 to C40 aliphatic hydrocarbon such as hexadecane, octadecane, or squalane, an aromatic hydrocarbon substituted with a C6 to C30 alkyl group such as phenyldodecane, phenyltetradecane, or phenyl hexadecane, a primary, secondary, or tertiary phosphine (e.g., triocty phosphine ) substituted with at least one (e.g., 1, 2, or 3) C6 to C22 alkyl group, a phosphine oxide (e.g. trioctylphosphine oxide) substituted with a (e.g., 1, 2, or 3) C6 to C22 alkyl group, a C12 to C22 aromatic ether such as phenyl ether or benzyl ether, or a combination thereof.

The organic ligand may coordinate the surfaces of the prepared semiconductor nanoparticles and allow the semiconductor nanoparticles to be well dispersed in the solution. The organic ligand may include $RCOOH$, $RNH_2$, $R_2NH$, $R_3N$, $RSH$, $RH_2PO$, $R_2HPO$, $R_3PO$, $RH_2P$, $R_2HP$, $R_3P$, $ROH$, $RCOOR'$, $RPO(OH)_2$, $R_2POOH$, (wherein R and R' independently include substituted or unsubstituted C1 or more, C6 or more, or C10 or more and C40 or less, C35 or less, or C25 or less aliphatic hydrocarbon group, or substituted or unsubstituted C6 to C40 aromatic hydrocarbon group, or a combination thereof), or a combination thereof. The ligands may be used alone or as a mixture of two or more compounds.

Examples of the organic ligand may be a thiol compound such as methane thiol, ethane thiol, propane thiol, butane thiol, pentane thiol, hexane thiol, octane thiol, dodecane thiol, hexadecane thiol, octadecane thiol, benzyl thiol, and the like; amines such as methane amine, ethane amine, propane amine, butane amine, pentyl amine, hexyl amine, octyl amine, nonylamine, decylamine, dodecyl amine, hexadecyl amine, octadecyl amine, dimethyl amine, diethyl amine, dipropyl amine, tributylamine, trioctylamine, and the like; a carboxylic acid compound such as methanoic acid, ethanoic acid, propanoic acid, butanoic acid, pentanoic acid, hexanoic acid, heptanoic acid, octanoic acid, dodecanoic acid, hexadecanoic acid, octadecanoic acid, oleic acid, myristic acid, stearic acid, lauric acid, benzoic acid, and the like; a phosphine compound such as methyl phosphine, ethyl phosphine, propyl phosphine, butyl phosphine, pentyl phosphine, octylphosphine, dioctyl phosphine, tributylphosphine, trioctylphosphine, and the like; a phosphine oxide compound thereof such as methyl phosphine oxide, ethyl phosphine oxide, propyl phosphine oxide, butyl phosphine oxide, pentyl phosphine oxide, tributylphosphine oxide, octylphosphine oxide, dioctyl phosphine oxide, trioctylphosphine oxide, and the like; diphenyl phosphine, triphenyl phosphine compound (DPP) or an oxide compound thereof; C5 to C20 alkyl phosphinic acid such as hexylphosphinic acid, octylphosphinic acid, dodecanephosphinic acid, tetradecanephosphinic acid, hexadecanephosphinic acid, octadecanephosphinic acid; C5 to C20 alkyl phosphonic acid; and the like, but is not limited thereof.

The semiconductor nanoparticle may be recovered by a process of pouring a non-solvent into a mixture including the semiconductor nanoparticle and subjecting the mixture to a centrifugation in order to remove excess organic substance that is not coordinated on the surface from them. For example, in an embodiment, after completing the reaction (for the formation of the core or for the formation of the shell), a non-solvent may be added to a reaction mixture and the semiconductor nanoparticle coordinated with the ligand compound may be separated therefrom. The non-solvent may be a polar solvent that is miscible with the solvent used in the core formation reactions, shell formation reaction, or a combination thereof, and is not capable of dispersing the prepared semiconductor nanoparticles. The non-solvent may be selected depending on the solvent used in the reaction and may include, for example, acetone, ethanol, butanol, isopropanol, ethanediol, water, tetrahydrofuran (THF), dimethylsulfoxide (DMSO), diethylether, formaldehyde, acetaldehyde, a solvent having a similar solubility parameter to the foregoing non-solvents, or a combination thereof. The semiconductor nanoparticles may be separated through centrifugation, sedimentation, or chromatography. The separated semiconductor nanoparticles may be washed with a washing solvent, if desired. The washing solvent has no particular limit and may have a similar solubility parameter to that of the ligand and may, for example, include hexane, heptane, octane, chloroform, toluene, benzene, and the like.

The semiconductor nanoparticles of an embodiment may be non-dispersible or insoluble in water, the aforementioned non-solvent, or a combination thereof. The semiconductor nanoparticles of an embodiment may be dispersed in the aforementioned organic solvent. In an embodiment, the aforementioned semiconductor nanoparticles may be dispersed in a substituted or unsubstituted C6 to C40 aliphatic hydrocarbon, a substituted or unsubstituted C6 to C40 aromatic hydrocarbon, or a combination thereof.

In the electroluminescent device or the display device of an embodiment, a thickness of the light-emitting layer may be appropriately selected. In an embodiment, the light-emitting layer may include a monolayer of nanoparticles. In an embodiment, the light-emitting layer may include one or more, for example, two or more, three or more, or four or more and 20 or less, 10 or less, 9 or less, 8 or less, 7 or less, or 6 or less monolayers of semiconductor nanoparticles. The light-emitting layer may have a thickness of greater than or equal to about 5 nm, for example, greater than or equal to about 10 nm, greater than or equal to about 20 nm, or greater than or equal to about 30 nm and less than or equal to about 200 nm, less than or equal to about 150 nm, less than or equal to about 100 nm, less than or equal to about 90 nm, less than or equal to about 80 nm, less than or equal to about 70 nm, less than or equal to about 60 nm, or less than or equal to about 50 nm. The light-emitting layer may have a thickness of, for example, about 10 nm to about 150 nm, about 20 nm to about 100 nm, or about 30 nm to about 50 nm.

In an embodiment, the disposing (e.g., forming) of the light-emitting layer 3 including the semiconductor nanoparticle may be performed by providing a composition including a semiconductor nanoparticle and an organic solvent and applying or depositing the same on a substrate (e.g., an electrode) or a charge auxiliary layer (e.g., a hole auxiliary layer or electron auxiliary layer) in an appropriate manner (e.g., by spin coating, inkjet printing, etc.).

The forming of the light-emitting layer may further include heat-treating the coated or deposited semiconductor nanoparticle layer. The heat-treating (e.g., thermal treatment, or heat treatment) temperature is not particularly limited, and it can be appropriately selected taking into consideration the boiling point of the organic solvent. For example, the heat treatment temperature may be greater than or equal to about 60°C, or greater than or equal to about 70 °C, and less than or equal to about 250 °C, or less than or equal to about 180 °C. A type of the organic solvent for the coating liquid is not particularly limited and may be selected appropriately. In an embodiment, the organic solvent may include a substituted or unsubstituted aliphatic hydrocarbon organic solvent, a substituted or unsubstituted aromatic hydrocarbon solvent, a substituted or unsubstituted alicyclic hydrocarbon solvent, an acetate solvent, or a combination thereof.

In an embodiment, the light-emitting layer may be a single layer or a multi-layered structure having at least two layers. In the multi-layered structure, adjacent layers (e.g., a first light-emitting layer and a second light-emitting layer) may be configured to emit a first light (e.g., green light, blue light, or red light). In the multi-layered structure, adjacent layers (e.g., a first light-emitting layer and a second light-emitting layer) may have the same or different composition, ligands, or a combination thereof. In an embodiment, the (multi-layered) light-emitting layer may have a halogen amount that varies (increase or decrease) in a thickness direction. In an embodiment, in the (multi-layered) light-emitting layer, the amount of the halogen may increase in a direction toward the electron auxiliary layer. In the (multi-layered) light-emitting layer, an amount, or a content of an organic ligand may decrease in the direction toward the electron auxiliary layer. In the (multi-layered) light-emitting layer, the amount, or the content of the organic ligand may increase in the direction toward the electron auxiliary layer.

In an embodiment, the light-emitting layer may include a first light-emitting layer including a first semiconductor nanoparticle and a second light-emitting layer including a second semiconductor nanoparticle, wherein the first semiconductor nanoparticle has a halogen (e.g., chlorine) exchanged surface and the second light-emitting layer has an increased amount of an organic ligand. A halogen (e.g., chlorine) amount and an organic ligand amount of the light-emitting layer may be controlled with an appropriate manner (e.g., a post treatment for the formed layer). In an embodiment, a thin film of the semiconductor nanoparticles having an organic ligand (e.g., having a carboxylic acid group) is formed, which is then treated with a solution including a metal halide (e.g., a zinc halide such as a zinc chloride in alcohol solvent) to control (decrease) an amount of the organic ligand of the semiconductor nanoparticles in the thin film. The treated thin film may have an increased halogen amount, exhibiting, a changed property (e.g., solubility) relative to an organic solvent, and it may be possible to form a layer of semiconductor nanoparticles having a different amount of an organic ligand (e.g., a halogen treated semiconductor nanoparticle or a semiconductor nanoparticle with a ligand having a carboxylic acid group) on the treated thin film, subsequently.

An electron auxiliary layer (including an electron transport layer) 4, or 40, may be disposed on the light-emitting layer 3, or 30, for example, between the light-emitting layer and the second electrode 5, or 50. In the electron auxiliary layer 4, or 40, transporting, injecting, or transporting and injecting of electrons may occur. The electron auxiliary layer 4, or 40, includes an electron transport layer (ETL). The electron auxiliary layer 4, or 40, may further include an electron injection layer, a hole blocking layer, or a combination thereof. The electron injection layer, the hole blocking layer, or a combination thereof, may be disposed between the electron transport layer and the second electrode, but it is not limited thereto. The electron transport layer includes a zinc oxide nanoparticle (e.g., a plurality of zinc oxide nanoparticles).

The zinc oxide nanoparticle may have a size or an average size (hereinafter, "size") of greater than or equal to about 1 nm, greater than or equal to about 3 nm, greater than or equal to about 5 nm, greater than or equal to about 7 nm. The zinc oxide nanoparticles may have a size of less than or equal to about 15 nm, less than or equal to about 13 nm, less than or equal to about 10 nm, less than or equal to about 8 nm, less than or equal to about 7 nm, less than or equal to about 6 nm, less than or equal to about 5 nm, less than or equal to about 4.5 nm, or less than or equal to about 4 nm. A particle size distribution of the zinc oxide nanoparticle may be unimodal (e.g., mono-disperse). A particle size distribution of the zinc oxide nanoparticles may be multimodal distribution (e.g., a bimodal distribution). The size may be a diameter (or an equivalent diameter calculated under an assumption of a spherical shape) of the particle. The size of the zinc oxide nanoparticle may be measured using an appropriate measurement tool (e.g., from a transmission electro-microscopy analysis).

The zinc oxide nanoparticle further includes magnesium and aluminum (e.g., within each particle). The electron transport layer may be adjacent to the light-emitting layer (e.g., directly disposed on the light-emitting layer). In an implementation, the electron transport layer may contact the light-emitting layer. A charge control layer formed of a metal component may not be disposed between the light-emitting layer and the electron transport layer.

In an embodiment, the electron transport layer may contribute to improving an electroluminescence property and extending a life-span of the device by adopting the features described herein. The present inventors have found that a zinc oxide nanoparticle further containing magnesium may exhibit a smaller particle size and may have a lower HOMO energy level and increased optical bandgap (or increased bandgap energy) in comparison with a ZnO nanoparticle that does not contain magnesium. Without wishing to be bound by any theory, it is believed that the features of the zinc oxide nanoparticle further containing magnesium can lead to an increase in an electron injection inhibition and a hole blocking ability, and thus an electroluminescent device containing these nanoparticles in the electron transport layer may exhibit improved luminescent properties and lifespan. However, the present inventors have also found that an amount of the magnesium included in a zinc oxide nanoparticle may adversely affect a current injection property, and there remains a technological drawback in light of achieving a desired performance improvement and an extension of lifespan.

Aluminum may be incorporated in a zinc oxide nanoparticle, but the present inventors have found that the incorporation of the aluminum into the zinc oxide nanoparticle in the electron transport layer may cause an increased current leakage for example when the electron transport layer is combined with a light-emitting layer containing a cadmium free semiconductor nanoparticle, resulting in a reduced electroluminescent property in the device.

Surprisingly, the present inventors have found that a zinc oxide nanoparticle containing aluminum and magnesium as described herein may be adopted in an electron transport layer to exhibit improved electroluminescence properties and extended lifespan (e.g., even when being combined with a light-emitting layer including a cadmium free semiconductor nanoparticle). The present inventors have also found that the aluminum and magnesium-containing zinc oxide nanoparticle prepared by the method described herein may have a controlled composition and may exhibit a UV-Vis absorption characteristic that is different from those of conventional zinc oxide nanoparticles.

In the electron transport layer of an embodiment, the zinc oxide nanoparticle may have an aluminum amount of greater than or equal to about 0.5 mol% (greater than or equal to about 0.005:1 as a mole ratio) and less or equal to about 30 mol% (less than or equal to about 0.30:1 as a mole ratio), based on a total amount of zinc, magnesium, and aluminum. In the zinc oxide nanoparticle, a mole ratio of aluminum to magnesium (Al:Mg) may be less than or equal to about 2:1, less than or equal to about 1.7:1, or less than or equal to about 1.5:1. The mole ratio of aluminum to magnesium (Al:Mg) may be greater than or equal to about 0.1:1.

In an embodiment, the zinc oxide nanoparticle can include magnesium and aluminum within the particles. In an embodiment, the zinc oxide nanoparticle may include a zinc oxide, a magnesium oxide, and an aluminum oxide. In an embodiment, the zinc oxide nanoparticle may include aluminum at a higher concentration at a portion closer to a surface of the nanoparticle than an inner portion thereof. The zinc oxide nanoparticle may have a core-shell structure. In an embodiment, the magnesium concentration and the aluminum concentration in the shell of the zinc oxide nanoparticles may be higher than in the core. In an embodiment, the magnesium concentration and the aluminum concentration in the shell of the zinc oxide nanoparticle may be lower than in the core.

In the electron transport layer or the zinc oxide nanoparticle, the moles of aluminum may be, based on a total sum of moles of zinc, magnesium, and aluminum, greater than or equal to about 1 mol%, greater than or equal to about 1.3 mol%, greater than or equal to about 1.5 mol%, greater than or equal to about 1.7 mol%, greater than or equal to about 1.9 mol%, greater than or equal to about 2 mol%, greater than or equal to about 2.1 mol%, greater than or equal to about 2.3 mol%, greater than or equal to about 2.5 mol%, greater than or equal to about 2.7 mol%, greater than or equal to about 2.9 mol%, greater than or equal to about 3 mol%, greater than or equal to about 3.1 mol%, greater than or equal to about 3.3 mol%, greater than or equal to about 3.5 mol%, greater than or equal to about 3.7 mol%, greater than or equal to about 3.9 mol%, greater than or equal to about 4 mol%, greater than or equal to about 4.1 mol%, greater than or equal to about 4.3 mol%, greater than or equal to about 4.5 mol%, greater than or equal to about 4.7 mol%, greater than or equal to about 4.9 mol%, greater than or equal to about 5 mol%, greater than or equal to about 5.5 mol%, greater than or equal to about 6 mol%, greater than or equal to about 6.5 mol%, greater than or equal to about 7 mol%, greater than or equal to about 7.5 mol%, greater than or equal to about 8 mol%, greater than or equal to about 8.5 mol%, greater than or equal to about 9 mol%, greater than or equal to about 9.5 mol%, greater than or equal to about 10 mol%, greater than or equal to about 10.5 mol%, or greater than or equal to about 14.5 mol%.

In the electron transport layer or the zinc oxide nanoparticle, the moles of aluminum may be, based on a total sum of moles of zinc, magnesium, and aluminum, less than or equal to about 29 mol%, less than or equal to about 28 mol%, less than or equal to about 26 mol%, less than or equal to about 24 mol%, less than or equal to about 22 mol%, less than or equal to about 20 mol%, less than or equal to about 18 mol%, less than or equal to about 16 mol%, less than or equal to about 14 mol%, less than or equal to about 12 mol%, less than or equal to about 10 mol%, or less than or equal to about 8 mol%.

In the electron transport layer or the zinc oxide nanoparticle, a mole ratio of magnesium to zinc (Mg:Zn) may be greater than or equal to about 0.035:1, greater than or equal to about 0.04:1, greater than or equal to about 0.045:1, greater than or equal to about 0.05:1, greater than or equal to about 0.07:1, greater than or equal to about 0.09:1, greater than or equal to about 0.1:1, greater than or equal to about 0.11:1, greater than or equal to about 0.12:1, greater than or equal to about 0.13:1, greater than or equal to about 0.14:1, greater than or equal to about 0.145:1, greater than or equal to about 0.15:1, greater than or equal to about 0.155:1, or greater than or equal to about 0.16:1. In the electron transport layer or the zinc oxide nanoparticle, a mole ratio of magnesium to zinc (Mg:Zn) may be less than or equal to about 0.7:1, less than or equal to about 0.5:1, less than or equal to about 0.35:1, less than or equal to about 0.3:1, less than or equal to about 0.29:1, less than or equal to about 0.28:1, less than or equal to about 0.26:1, less than or equal to about 0.24:1, less than or equal to about 0.22:1, less than or equal to about 0.21:1, less than or equal to about 0.2:1, less than or equal to about 0.18:1, less than or equal to about 0.17:1, less than or equal to about 0.16:1, less than or equal to about 0.155:1, less than or equal to about 0.15:1, less than or equal to about 0.145:1, less than or equal to about 0.14:1, less than or equal to about 0.13:1, less than or equal to about 0.12:1, less than or equal to about 0.11:1, or less than or equal to about 0.1:1.

In the electron transport layer or the zinc oxide nanoparticle, a mole ratio of aluminum to magnesium (Al:Mg) may be greater than or equal to about 0.05:1, greater than or equal to about 0.1:1, greater than or equal to about 0.12:1, greater than or equal to about 0.14:1, greater than or equal to about 0.16:1, greater than or equal to about 0.18:1, greater than or equal to about 0.2:1, greater than or equal to about 0.22:1, greater than or equal to about 0.24:1, greater than or equal to about 0.26:1, greater than or equal to about 0.28:1, greater than or equal to about 0.3:1, greater than or equal to about 0.32:1, greater than or equal to about 0.34:1, greater than or equal to about 0.36:1, greater than or equal to about 0.38:1, greater than or equal to about 0.4:1, greater than or equal to about 0.42:1, greater than or equal to about 0.44:1, greater than or equal to about 0.46:1, greater than or equal to about 0.48:1, greater than or equal to about 0.5:1, greater than or equal to about 0.52:1, greater than or equal to about 0.54:1, greater than or equal to about 0.56:1, greater than or equal to about 0.58:1, greater than or equal to about 0.59:1, greater than or equal to about 0.6:1, greater than or equal to about 0.65:1, greater than or equal to about 0.7:1, or greater than or equal to about 0.75:1. In the electron transport layer or the zinc oxide nanoparticle, a mole ratio of aluminum to magnesium (Al:Mg) may be less than or equal to about 3:1, less than or equal to about 2.5:1, less than or equal to about 2:1, less than or equal to about 1.5:1, less than or equal to about 1.3:1, less than or equal to about 1:1, less than or equal to about 0.9:1, or less than or equal to about 0.75:1.

In the electron transport layer or the zinc oxide nanoparticle, a mole ratio of aluminum to zinc (Al:Zn) may be greater than or equal to about 0.01:1, greater than or equal to about 0.015:1, greater than or equal to about 0.02:1, greater than or equal to about 0.025:1, greater than or equal to about 0.03:1, greater than or equal to about 0.035:1, greater than or equal to about 0.04:1, greater than or equal to about 0.045:1, greater than or equal to about 0.05:1, greater than or equal to about 0.055:1, greater than or equal to about 0.06:1, greater than or equal to about 0.065:1, greater than or equal to about 0.07:1, greater than or equal to about 0.075:1, greater than or equal to about 0.08:1, greater than or equal to about 0.085:1, greater than or equal to about 0.09:1, greater than or equal to about 0.095:1, greater than or equal to about 0.1:1, greater than or equal to about 0.11:1, greater than or equal to about 0.12:1, greater than or equal to about 0.13:1, greater than or equal to about 0.14:1, greater than or equal to about 0.15:1, greater than or equal to about 0.16:1, greater than or equal to about 0.17:1, greater than or equal to about 0.18:1, greater than or equal to about 0.19:1, or greater than or equal to about 0.21:1. In the electron transport layer or the zinc oxide nanoparticle, a mole ratio of aluminum to zinc (Al:Zn) may be less than or equal to about 0.5:1, less than or equal to about 0.45:1, less than or equal to about 0.4:1, less than or equal to about 0.35:1, less than or equal to about 0.3:1, less than or equal to about 0.25:1, less than or equal to about 0.2:1, or less than or equal to about 0.15:1.

In the electron transport layer or the zinc oxide nanoparticle, a mole ratio of a sum of magnesium and aluminum to zinc [(Mg+Al):Zn] may be greater than or equal to about 0.1:1, greater than or equal to about 0.12:1, greater than or equal to about 0.135:1, greater than or equal to about 0.14:1, greater than or equal to about 0.15:1, greater than or equal to about 0.155:1, greater than or equal to about 0.16:1, greater than or equal to about 0.165:1, greater than or equal to about 0.17:1, greater than or equal to about 0.175:1, greater than or equal to about 0.18:1, greater than or equal to about 0.185:1, greater than or equal to about 0.19:1, greater than or equal to about 0.195:1, greater than or equal to about 0.2:1, greater than or equal to about 0.205:1, greater than or equal to about 0.21:1, greater than or equal to about 0.215:1, greater than or equal to about 0.22:1, greater than or equal to about 0.225:1, greater than or equal to about 0.23:1, greater than or equal to about 0.235:1, greater than or equal to about 0.24:1, greater than or equal to about 0.245:1, greater than or equal to about 0.25:1, greater than or equal to about 0.255:1, greater than or equal to about 0.26:1, greater than or equal to about 0.265:1, greater than or equal to about 0.27:1, greater than or equal to about 0.275:1, or greater than or equal to about 0.28:1. In the electron transport layer or the zinc oxide nanoparticle, a mole ratio of a sum of magnesium and aluminum to zinc [(Mg+Al):Zn] may be less than or equal to about 0.7:1, less than or equal to about 0.6:1, less than or equal to about 0.5:1, less than or equal to about 0.45:1, less than or equal to about 0.4:1, less than or equal to about 0.35:1, less than or equal to about 0.33:1, less than or equal to about 0.31:1, less than or equal to about 0.29:1, less than or equal to about 0.26:1, less than or equal to about 0.255:1, less than or equal to about 0.245:1, less than or equal to about 0.235:1, less than or equal to about 0.23:1, or less than or equal to about 0.2:1.

The zinc oxide nanoparticle may include an additional metal and the additional metal may include an alkali metal, calcium, zirconium (Zr), tungsten (W), titanium (Ti), yttrium (Y), gallium (Ga), or a combination thereof. The alkali metal may include lithium, sodium, potassium, rubidium, cesium, francium, or a combination thereof. The zinc oxide nanoparticle may further include a halogen. The halogen may include chlorine, fluorine, bromine, iodine, or a combination thereof. The alkali metal may include potassium, cesium, rubidium, or a combination thereof, and the halogen may include chlorine. The additional metal may include gallium.

In the zinc oxide nanoparticle or the electron transport layer, a concentration of the additional metal may be controlled appropriately. In the zinc oxide nanoparticle or the electron transport layer of an embodiment, a mole ratio of the additional metal to the zinc may be greater than or equal to about 0.01:1, greater than or equal to about 0.03:1, greater than or equal to about 0.05:1, greater than or equal to about 0.07:1, greater than or equal to about 0.1:1, greater than or equal to about 0.13:1, greater than or equal to about 0.15:1, greater than or equal to about 0.17:1, greater than or equal to about 0.2:1, greater than or equal to about 0.23:1, or greater than or equal to about 0.25:1. The mole ratio of the additional metal to the zinc may be less than or equal to about 0.47:1, less than or equal to about 0.45:1, less than or equal to about 0.43:1, less than or equal to about 0.4:1, less than or equal to about 0.37:1, less than or equal to about 0.35:1, or less than or equal to about 0.3:1.

In an embodiment, the zinc oxide nanoparticle may further include an alkali metal, and in the electron transport layer or the zinc oxide nanoparticle, a mole ratio of the alkali metal to the aluminum may be greater than or equal to about 0.1:1, greater than or equal to about 0.15:1, greater than or equal to about 0.2:1, greater than or equal to about 0.25:1, greater than or equal to about 0.3:1, greater than or equal to about 0.35:1, greater than or equal to about 0.4:1, greater than or equal to about 0.45:1, greater than or equal to about 0.5:1, greater than or equal to about 0.55:1, greater than or equal to about 0.6:1, greater than or equal to about 0.65:1, greater than or equal to about 0.7:1, greater than or equal to about 0.75:1, or greater than or equal to about 0.8:1. In an embodiment, the mole ratio of the alkali metal to the aluminum may be less than or equal to about 2:1, less than or equal to about 1.5:1, less than or equal to about 1.2:1, less than or equal to about 1:1, less than or equal to about 0.9:1, less than or equal to about 0.88:1, less than or equal to about 0.84:1, or less than or equal to about 0.76:1.

In an embodiment, in the zinc oxide nanoparticle or the electron transport layer, a mole ratio of halogen to aluminum may be, as determined by an X-ray photoelectron spectroscopy analysis (XPS), greater than or equal to about 0.01:1, greater than or equal to about 0.03:1, greater than or equal to about 0.05:1, greater than or equal to about 0.07:1, greater than or equal to about 0.09:1, greater than or equal to about 0.1:1, greater than or equal to about 0.11:1, greater than or equal to about 0.12:1, greater than or equal to about 0.13:1, greater than or equal to about 0.14:1, greater than or equal to about 0.15:1, greater than or equal to about 0.16:1, or greater than or equal to about 0.17:1. In the zinc oxide nanoparticle or the electron transport layer, a mole ratio of halogen to aluminum may be, as determined by an X-ray photoelectron spectroscopy analysis (XPS), less than or equal to about 0.5:1, less than or equal to about 0.45:1, less than or equal to about 0.4:1, less than or equal to about 0.35:1, less than or equal to about 0.3:1, less than or equal to about 0.25:1, less than or equal to about 0.2:1, or less than or equal to about 0.19:1. Without wishing to be bound by any theory, in the zinc oxide nanoparticle or the electron transport layer of an embodiment, the halogen may provide additional passivation and/or enhanced coordination of organic materials to the zinc oxide nanoparticle.

A feature such as the presence of each component in a zinc oxide nanoparticle or the electron transport layer or a feature such as a mole ratio between the components may be determined or measured by an appropriate analysis tool (X-ray photoelectron spectroscopy (XPS), an inductively coupled plasma atomic emission spectroscopy, scanning or transmission electron microscope energy dispersion spectroscopy, etc.).

In an embodiment, as analyzed by UV-Vis absorption spectroscopy, the zinc oxide nanoparticle may exhibit a first absorption peak wavelength of less than or equal to about 324 nm, less than or equal to about 323 nm, less than or equal to about 322 nm, less than or equal to about 321 nm, less than or equal to about 320 nm, less than or equal to about 319 nm, less than or equal to about 318 nm, less than or equal to about 317 nm, less than or equal to about 316 nm, less than or equal to about 315 nm, less than or equal to about 314 nm, less than or equal to about 313 nm, less than or equal to about 312 nm, or less than or equal to about 311 nm. The first absorption peak wavelength may be greater than or equal to about 310 nm, greater than or equal to about 312 nm, greater than or equal to about 314 nm, greater than or equal to about 316 nm, or greater than or equal to about 318 nm. The zinc oxide nanoparticle may have a bandgap energy of greater than or equal to about 3.5 eV, greater than or equal to about 3.55 eV, greater than or equal to about 3.6 eV, greater than or equal to about 3.65 eV, greater than or equal to about 3.7 eV, greater than or equal to about 3.72 eV, greater than or equal to about 3.75 eV, greater than or equal to about 3.77 eV, greater than or equal to about 3.8 eV, greater than or equal to about 3.83 eV, greater than or equal to about 3.85 eV, greater than or equal to about 3.87 eV, greater than or equal to about 3.9 eV, or greater than or equal to about 3.92 eV and less than or equal to about 4.2 eV, less than or equal to about 4.18 eV, less than or equal to about 4.15 eV, less than or equal to about 4.13 eV, less than or equal to about 4.1 eV, less than or equal to about 4.05 eV, less than or equal to about 4 eV, less than or equal to about 3.98 eV, less than or equal to about 3.95 eV, less than or equal to about 3.93 eV, less than or equal to about 3.91 eV, or less than or equal to about 3.86 eV.

In an electroluminescent device of an embodiment, the zinc oxide nanoparticle may be prepared by the method described herein. In an embodiment, unlike the conventional art based on the sol-gel hydration reaction, the zinc oxide nanoparticle including magnesium and aluminum may be synthesized by a method involving a phase transition and separation mechanism (e.g., a liquid-solid-solution synthesis, LSS synthesis) which occurs at the interface of liquid, solid, and solution phases present during the synthesis. Without wishing to be bound by any theory, it is believed that the zinc oxide nanoparticle obtained by the method of an embodiment involving the LSS synthesis as described herein may have an improved crystallinity in comparison with the nanoparticle prepared in the conventional art (the sol gel method), and may exhibit an improved solubility. Surprisingly, the present inventors have found that the inclusion of the zinc oxide nanoparticle prepared by the method of an embodiment in the electron transport layer may contribute to improving an electroluminescent property and a life-span of a resulting device. Further details of the preparation of zinc oxide nanoparticles will be described herein.

In an X-ray diffraction analysis of the zinc oxide nanoparticle of an embodiment, a peak percentage defined by the following equation may be greater than or equal to about 1%, greater than or equal to about 1.5%, or greater than or equal to about 3%:

$$\text{Peak percentage (\%)} = [B/A] \times 100,$$

A: a maximum intensity of a peak present in a 2 theta range of from about 65 degrees to about 75 degrees, and
B: a maximum intensity of a peak present in a 2 theta range of from about 25 degrees to about 35 degrees.

The peak percentage may be greater than or equal to about 2%, greater than or equal to about 3%, greater than or equal to about 5%, greater than or equal to about 6%, greater than or equal to about 7%, greater than or equal to about 8%, greater than or equal to about 9%, greater than or equal to about 10%, greater than or equal to about 12%, greater than or equal to about 15%, greater than or equal to about 17%, greater than or equal to about 20%, or greater than or equal to about 23%. The peak percentage may be in a range of from about 2.5% to about 30%, from about 3.5% to about 15%, from about 4% to about 13%, from about 6% to about 11%, or a combination thereof.

In addition, in the electroluminescent device of an embodiment, the zinc oxide nanoparticle may provide a proper dispersibility (for example, desired for a solution process). In an embodiment, the zinc oxide nanoparticle may be dispersed in a C1 to C10 alcohol solvent.

In an embodiment, the zinc oxide nanoparticle may exhibit, as dispersed in an alcohol solvent and measured by a dynamic light scattering analysis, an average particle diameter (may be referred to as a DLS average particle diameter, as well) of greater than or equal to about 4.5 nm, greater than or equal to about 5 nm, greater than or equal to about 5.5 nm, greater than or equal to about 6 nm, greater than or equal to about 6.5 nm, greater than or equal to about 7 nm, or greater than or equal to about 7.5 nm. The DLS average particle diameter of the zinc oxide nanoparticle may be less than or equal to about 500 nm, less than or equal to about 400 nm, less than or equal to about 300 nm, less than or equal to about 200 nm, less than or equal to about 100 nm, less than or equal to about 80 nm, less than or equal to about 50 nm, less than or equal to about 10 nm, less than or equal to about less than or equal to about 9 nm, less than or equal to about 8.5 nm, less than or equal to about 8 nm, less than or equal to about 7.5 nm, or less than or equal to about 7 nm.

In an embodiment, the zinc oxide nanoparticle may form a solution in ethanol that is transparent to the naked eye. In an embodiment, the zinc oxide nanoparticle above is dispersed in ethanol, and the dispersion may pass through a filter having a pore size of less than or equal to about 0.45 $\mu$m, for example, less than or equal to about 0.3 $\mu$m, less than or equal to about 0.2 $\mu$m, of less than or equal to about 0.1 $\mu$m.

When the zinc oxide nanoparticle of the embodiment forms a thin film for an electron transport layer (for example, having a thickness of about 20 nm), the thin film of the zinc oxide nanoparticle of an embodiment may show a significantly reduced number of thin film voids. The void of the thin film may have a depth of 5 nm or more as confirmed by an atomic force microscope.

In an embodiment, the thin film of the zinc oxide nanoparticles above may exhibit a maximum or a minimum height of less than 5 nm, for example, 4 nm or less, or 3 nm or less, in the AFM height profile, when confirmed by an atomic force microscope. In an embodiment, a difference between the maximum height and the minimum height may be less than or equal to about 6 nm, less than or equal to about 5 nm, less than or equal to about 4 nm, or less than or equal to about 3 nm.

The zinc oxide nanoparticle may include, based on a total weight of the zinc oxide nanoparticles, an amount of an organic substance that is greater than or equal to about 1 weight percent (wt%), greater than or equal to about 3 wt%, greater than or equal to about 5 wt%, greater than or equal to about 7 wt%, greater than or equal to about 10 wt%, greater than or equal to about 15 wt%, greater than or equal to about 17 wt%, greater than or equal to about 19 wt%, greater than or equal to about 20 wt%, greater than or equal to about 25 wt%, greater than or equal to about 26 wt%, greater than or equal to about 26.5 wt%, greater than or equal to about 27 wt%, greater than or equal to about 28 wt %, greater than or equal to about 29 wt %, or greater than or equal to about 30 wt%, based on a total weight of the zinc oxide nanoparticles. In the zinc oxide particles, the amount of the organic material may be less than or equal to about 35 wt%, less than or equal to about 34.5 wt%, less than or equal to about 34 wt%, less than or equal to about 33.5 wt%, less than or equal to about 33 wt%, less than or equal to about 31 wt%, less than or equal to about 30 wt %, less than or equal to about 29.5 wt%, less than or equal to about 27 wt %, less than or equal to about less than about 25 wt%, less than or equal to about 24.5 wt%, less than or equal to about 24 wt%, or less than or equal to about 23.5 wt%, for example, as determined by a thermogravimetric analysis.

In an embodiment, the electroluminescent device may further include a hole auxiliary layer 2, or 20, between the first electrode 1, or 10, and the light-emitting layer 3, or 30. The hole auxiliary layer 2, or 20, may include a hole injection layer, a hole transport layer, an electron blocking layer, or a combination thereof. The hole auxiliary layer 2, or 20, may be a single layer or a multilayer structure in which adjacent layers include different components (see, e.g., FIGS. 1 to 3).

The hole auxiliary layer 2, or 20, may have a HOMO energy level that can be matched with the HOMO energy level of the light-emitting layer 3, or 30, in order to enhance mobility of holes transferred from the hole auxiliary layer 2, or 20, to the light-emitting layer 3, or 30. In an embodiment, the hole auxiliary layer 2, or 20, may include a hole injection layer close to, e.g., adjacent, the first electrode 1, or 10, and a hole transport layer close to, e.g., adjacent, the light-emitting layer 3, or 30.

In an embodiment, the material included in the hole auxiliary layer 2, or 20 (e.g., a hole transport layer, a hole injection layer, or an electron blocking layer), is not particularly limited, and may include, for example, poly(9,9-dioctyl-fluorene-co-N-(4)-butylphenyl)-diphenylamine) (TFB), polyarylamine, poly(N-vinylcarbazole), poly(3,4-ethylenedioxythiophene) (PEDOT), poly(3,4-ethylenedioxythiophene): polystyrene sulfonate (PEDOT:PSS), polyaniline, polypyrrole, N,N,N',N'-tetrakis(4-methoxyphenyl)-benzidine (TPD), 4,4'-bis[N-(1-naphthyl)-N-phenyl-amino]biphenyl ($\alpha$-NPD), m-MTDATA (4,4',4"-Tris[phenyl(m-tolyl)amino]triphenylamine), 4,4',4"-tris(N-carbazolyl)-triphenylamine (TCTA), 1,1-bis[(di-4-toylamino)phenyl]cyclohexane (TAPC), a p-type metal oxide (e.g., NiO, $WO_3$, MoOs, etc.), a carbon-based material such as graphene oxide, or a combination thereof, but is not limited thereto.

In the hole auxiliary layer, a thickness of each layer may be appropriately selected. For example, the thickness of each layer may be greater than or equal to about 5 nm, greater than or equal to about 10 nm, greater than or equal to about 15 nm, or greater than or equal to about 20 nm and less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 35 nm, or less than or equal to about 30 nm, but is not limited thereto.

A device according to an embodiment may have a structure for example, as shown in FIG. 2. In an embodiment, and referring to FIG. 2, in the device, the anode 10 disposed on the transparent substrate 100 may include a metal oxide-based (i.e., metal oxide-containing) transparent electrode (e.g., an ITO electrode), and the cathode 50 facing the anode 10 may include a conductive metal (e.g., having a relatively low work function, such as Mg, Al, etc.). The hole auxiliary layer 20 (e.g., a hole injection layer such as PEDOT:PSS, or p-type metal oxide, or a hole transport layer such as TFB, or polyvinylcarbazole (PVK)) may be provided between the transparent electrode 100 and the light-emitting layer 30. The hole injection layer may be disposed close to the transparent electrode and the hole transport layer may be disposed close to the light-emitting layer. The electron auxiliary layer 40 such as an electron injection/transport layer may be disposed between the light-emitting layer 30 and the cathode 50.

A device according to another embodiment may have an inverted structure. Herein, the second electrode 50 disposed on the transparent substrate 100 may include a metal oxide-based transparent electrode (e.g., ITO), and the anode 10 facing the cathode 50 may include a metal (e.g., having a relatively high work function, such as Au, Ag, etc.). For example, an (optionally doped) n-type metal oxide (crystalline Zn metal oxide) or the like may be disposed as an electron auxiliary layer 40 (e.g., an electron transport layer) between the transparent electrode 50 and the light-emitting layer 30. MoOs or other p-type metal oxide may be disposed as a hole auxiliary layer 20 (e.g., a hole transport layer including TFB, or PVK, or a hole injection layer including $MoO_3$, or other p-type metal oxide) between the metal anode 10 and the light-emitting layer 30 (see FIG. 3).

The device described above may be manufactured by the method described herein. The method of manufacturing the electroluminescent device includes forming the light-emitting layer on the first electrode, applying a solution including the zinc oxide nanoparticle on the light-emitting layer and optionally heat-treating to form the electron transport layer, and forming the second electrode on the electron transport layer.

In an embodiment, the electroluminescent device may be produced by optionally forming a hole auxiliary layer (e.g., by deposition or coating) on a substrate on which an electrode is formed, forming a light-emitting layer including a semiconductor nanoparticle (e.g., a pattern of the aforementioned semiconductor nanoparticles) on the electrode, forming an electron transport layer; and optionally forming an electron auxiliary layer and an electrode (for example, by vapor deposition or coating) on the electron transport layer. A method of forming the electrode/hole auxiliary layer/electron auxiliary layer may be appropriately selected and is not particularly limited.

In the method of an embodiment, the zinc oxide nanoparticle is prepared by:

admixing a zinc precursor, a magnesium precursor, and aluminum precursor with a first solvent and a second solvent to obtain a first solution;
adding a base to the first solution to form to zinc oxide nanoparticle;
wherein a relative polarity difference between the first solvent and the second solvent is greater than or equal to about 0.1, greater than or equal to about 0.25, or greater than or equal to about 0.3 and less than or equal to about 0.9.

A reaction between the precursors may be facilitated or conducted by the addition of the base. The method may further include adding a third solvent to facilitate precipitation of the nanoparticle

The formed electron transport layer may be thermally treated.

The method may further include adding a third solvent to the first solution after the addition of the base to facilitate precipitation of the zinc oxide nanoparticle. The method may further include a stirring the first solution, for example, prior to or after the addition of the base.

In an embodiment, the obtaining of the first solution may include adding the zinc precursor, the magnesium precursor, and the aluminum precursor into the first solvent to dissolve the precursors and adding a second solvent to a resulting mixture.

In an embodiment, the obtaining of the first solution may include adding the zinc precursor, the magnesium precursor, and the aluminum precursor to a solvent mixture of the first solvent and the second solvent and dissolving the same.

Without wishing to be bound by any theory, it is believed that in the method of an embodiment, an extremely small sized segregated phase or a micro-reactor may be readily formed in the solvent mixture of the first solvent and the second solvent due to the polarity difference between the first solvent and the second solvent, and a movement (e.g., a phase transfer and/or a phase separation) and a reaction of precursors (solid) may occur to form a zinc oxide nanoparticle including magnesium and aluminum. Surprisingly, the present inventors have found that the zinc oxide nanoparticle formed by the method of an embodiment may exhibit improved crystallinity and dispersibility compared to the nanoparticle manufactured by the conventional sol-gel method, and the electroluminescent devices of an embodiment including the zinc oxide nanoparticle manufactured in this way may exhibit improved electroluminescence properties and increased life.

A difference between the relative polarities of the first solvent and the second solvent may be greater than or equal to about 0.35, greater than or equal to about 0.4, greater than or equal to about 0.45, greater than or equal to about 0.5, or greater than or equal to about 0.55. The difference between the relative polarities may be less than or equal to about 3, less than or equal to about 2, less than or equal to about 1, less than or equal to about 0.85, less than or equal to about 0.8, less than or equal to about 0.75, less than or equal to about 0.7, less than or equal to about 0.65, less than or equal to about 0.6, less than or equal to about 0.55, less than or equal to about 0.5, or less than or equal to about 0.45. The relative polarity of the solvents may be obtained from the literature (e.g., Solvents and solvent Effects in organic chemistry, Wiley VCH publisher, 3rd edition, 2003). For example, water has a relative polarity of about 1.

The first solvent may include a C1 to C10 alcohol solvent, for example, methanol, ethanol, propanol, isopropanol, butanol, isobutanol, pentenol, isopentenol, or a combination thereof. The first solvent may have relative polarity of greater than or equal to about 0.4, greater than or equal to about 0.45, greater than or equal to about 0.5, greater than or equal to about 0.55, greater than or equal to about 0.6, greater than or equal to about 0.65, greater than or equal to about 0.7, or greater than or equal to about 0.75. The relative polarity of the first solvent may be less than or equal to about 2, less than or equal to about 1, less than or equal to about 0.9, or any combination of the foregoing upper and lower limits.

The second solvent or the third solvent may include a C3 to C15 hydrocarbon solvent (aliphatic, aromatic, alicyclic, or hydrocarbon solvents including a hydrogenated benzene ring, for example, cyclohexane, hexane, heptane, nonane, octane, etc.), a C3 to C30 or C10 to C15 ester solvent (e.g., a C1 to C30 or C2-15 alkyl acetate solvent such as ethyl acetate), dichloroethane, chloroform, a C2 to C30 ketone solvent (e.g., methyl ethyl ketone), a dioxane, or combinations thereof. The substitution may be a halogen substitution and the halogen substitution may be a chlorine substitution. The hydrocarbon solvent may be a halogen (e.g., chlorine) substituted aliphatic, aromatic, alicyclic hydrocarbon solvent, for example, a chlorine substituted alkane solvent, a chlorine substituted alkene solvent, a chlorine substituted alkyne solvent, a chlorine substituted aromatic hydrocarbon solvent, a chlorine substituted alicyclic hydrocarbon solvent, or a combination thereof.

The second solvent or the third solvent may have a relative polarity of greater than or equal to about 0.001, greater than or equal to about 0.003, greater than or equal to about 0.006, greater than or equal to about 0.009, greater than or equal to about 0.01, or greater than or equal to about 0.012. The relative polarity of the second solvent or the third solvent may be less than or equal to about 4, less than or equal to about 3.5, less than or equal to about 3, less than or equal to about 2.5, less than or equal to about 2, less than or equal to about 1.5, less than or equal to about 1, less than or equal to about 0.5, less than or equal to about 0.1, less than or equal to about 0.05, or less than or equal to about 0.01. The second solvent and the third solvent may be the same or different with each other.

The relative polarity of the first solvent may be greater than the relative polarity of the second solvent (or the third solvent).

The first solvent may be miscible with water or may have a solubility in water of greater than or equal to about 5 g/100g, greater than or equal to about 6 g/100g, greater than or equal to about 8 g/100g, greater than or equal to about 10 g/100g, or greater than or equal to about 12 g/100g. The second solvent may have a solubility in water of less than or equal to about 1 g/100g, less than or equal to about 0.1 g/100g, less than or equal to about 0.05 g/100g or less.

In an embodiment, the second solvent may form a nanobubble or a microreactor in the first solvent. In an embodiment, the first solvent may form a nanobubble in the second solvent. A volume ratio of the second solvent to the first solvent may be from about 1:0.2 to about 1:5, from about 1:0.3 to about 1:3, from about 1:0.5 to about 1:2, from about 1:0.8 to about 1:1.25, from about 1:1 to about 1:1.5, or a combination thereof. In an embodiment, an amount of the first solvent may be greater than an amount of the second solvent. In an embodiment, an amount of the first solvent may be less than an amount of the second solvent.

The stirring may be performed at a speed of greater than or equal to about 100 rpm, greater than or equal to about 150 rpm, greater than or equal to about 200 rpm, greater than or equal to about 250 rpm, greater than or equal to about 300 rpm, greater than or equal to about 350 rpm, greater than or equal to about 400 rpm, greater than or equal to about 450 rpm, or greater than or equal to about 500 rpm. The stirring may be performed at a speed of less than or equal to about 800 rpm, less than or equal to about 700 rpm, or less than or equal to about 600 rpm.

In an embodiment, a temperature of the first solution (for example during a reaction of a particle formation after the addition of the base) may be greater than or equal to about 20 °C, greater than or equal to about 25 °C, greater than or equal to about 28 °C, greater than or equal to about 30 °C, or greater than or equal to about 40 °C. The temperature of the first solution may be less than or equal to about a boiling point of the first solvent or the second solvent, less than or equal to about 80 °C, less than or equal to about 78 °C, less than or equal to about 70 °C, less than or equal to about 60 °C, less than or equal to about 55 °C, less than or equal to about 50 °C, or less than or equal to about 45 °C.

An electroluminescent device of an embodiment may exhibit improved electroluminescent properties (e.g., along with an extended life-span as described above). The nanoparticle formed from the reaction system may be separated by an appropriate method and optionally, be washed. For the separation and the optional washing, a nonsolvent (e.g., a third solvent) may be added. The nonsolvent may include an ester-based solvent such as ethyl acetate. An excess amount of organic matter may be removed by washing.

In the method of an embodiment, the zinc precursor, the magnesium, precursor, and the aluminum precursor may be appropriately selected. The zinc precursor and/or the magnesium precursor may be added in a powder state. The zinc precursor and/or the magnesium precursor may include an acetate moiety.

The zinc precursor may include a zinc acetate, a zinc acetylacetonate, a zinc carboxylate, a zinc halide, a zinc nitride, a zinc oxide, or a combination thereof.

The magnesium precursor may include a magnesium acetate, a magnesium acetylacetonate, a magnesium carboxylate, a magnesium halide, a magnesium nitride, a magnesium oxide, or a combination thereof.

The aluminum precursor may include an aluminum acetate, an aluminum acetylacetonate, an aluminum carboxylate, an aluminum halide, an aluminum nitride, an aluminum oxide, or a combination thereof. The halide for the zinc halide, the magnesium halide, or the aluminum halide may include a chloride, a fluoride, a bromide, or an iodide. The aluminum halide may include an aluminum chloride.

The base may include an organic base, an inorganic base, or a combination thereof. The inorganic base may include an alkali metal hydroxide such as LiOH, KOH, NaOH, RbOH, CsOH, or a combination thereof, an alkaline earth metal hydroxide such as $Ca(OH)_2$, an inorganic ammonium compound, or a combination thereof. The organic base may include a primary amine, a secondary amine, a tertiary amine, an organic ammonium salt compound, or a combination thereof. The base may include or may not include a tetraalkylammonium hydroxide (e.g., tetramethylammonium hydroxide). The base may be added by being dissolved in the first solvent (e.g. an alcohol solvent such as ethanol).

In an embodiment, the electron transport layer may be provided through a solution process. In an embodiment, the electron transport layer may be formed by dispersing the zinc oxide nanoparticle in an organic solvent (e.g., a polar organic solvent, a non-polar organic solvent, or a combination thereof) to obtain a dispersion for forming an electron transport layer and applying the dispersion to form a film. In an embodiment, the dispersion for forming an electron transport layer may be applied on the light-emitting layer. The solution process may further include removing the organic solvent form the formed film (e.g., through evaporation, etc.).

In an embodiment, a thickness of the electron transport layer may be greater than or equal to about 5 nm, greater than or equal to about 6 nm, greater than or equal to about 7 nm, greater than or equal to about 8 nm, greater than or equal to about 9 nm, greater than or equal to about 10 nm, greater than or equal to about 11 nm, greater than or equal to about 12 nm, greater than or equal to about 13 nm, greater than or equal to about 14 nm, greater than or equal to about 15 nm, greater than or equal to about 16 nm, greater than or equal to about 17 nm, greater than or equal to about 18 nm, greater than or equal to about 19 nm, or greater than or equal to about 20 nm, and less than or equal to about 120 nm, less than or equal to about 110 nm, less than or equal to about 100 nm, less than or equal to about 90 nm, less than or equal to about 80 nm, less than or equal to about 70 nm, less than or equal to about 60 nm, less than or equal to about 50 nm, less than or equal to about 40 nm, less than or equal to about 30 nm, or less than or equal to about 25 nm, but is not limited thereto.

In an embodiment, an electron injection layer may be further disposed between the electron transport layer and the second electrode. The material of the electron injection layer is not particularly limited and can be selected appropriately.

The electroluminescent device of an embodiment may exhibit an improved electroluminescent property (e.g., together with a prolonged lifespan as described above).

In an embodiment, the electroluminescent device may have a maximum external quantum efficiency (EQE) of greater than or equal to about 5%, greater than or equal to about 5.5%, greater than or equal to about 6%, greater than or equal to about 6.5%, greater than or equal to about 7%, greater than or equal to about 7.5%, greater than or equal to about 7.7%, greater than or equal to about 8%, greater than or equal to about 8.5%, greater than or equal to about 9%, greater than or equal to about 9.5%, greater than or equal to about 10%, greater than or equal to about 10.5%, greater than or equal to about 11%, greater than or equal to about 11.5%, greater than or equal to about 12%, greater than or equal to about 12.5%, greater than or equal to about 13%, greater than or equal to about 13.5%, or greater than or equal to about 14%. The maximum external quantum efficiency (EQE) may be less than or equal to about 40%, less than or equal to about 30%, or less than or equal to about 20%.

The electroluminescent device of an embodiment may have a maximum luminance of greater than or equal to about 50,000 candelas per square meter ($cd/m^2$), greater than or equal to about 60,000 $cd/m^2$, greater than or equal to about 70,000 $cd/m^2$, greater than or equal to about 80,000 $cd/m^2$, greater than or equal to about 90,000 $cd/m^2$, greater than or equal to about 100,000 $cd/m^2$, greater than or equal to about 150,000 $cd/m^2$, greater than or equal to about 200,000 $cd/m^2$, greater than or equal to about 250,000 $cd/m^2$, greater than or equal to about 300,000 $cd/m^2$, greater than or equal to about 310,000 $cd/m^2$, greater than or equal to about 320,000 $cd/m^2$, greater than or equal to about 330,000 $cd/m^2$, greater than or equal to about 340,000 $cd/m^2$, greater than or equal to about 350,000 $cd/m^2$, greater than or equal to about 360,000 $cd/m^2$, greater than or equal to about 370,000 $cd/m^2$, greater than or equal to about 380,000 $cd/m^2$, greater than or equal to about 390,000 $cd/m^2$, greater than or equal to about 400,000 $cd/m^2$, greater than or equal to about 440,000 $cd/m^2$, greater than or equal to about 500,000 $cd/m^2$, or greater than or equal to about 550,000 $cd/m^2$. The maximum luminance may be from about 50,000 $cd/m^2$ to about 1,000,000 $cd/m^2$, from about 70,000

cd/m$^2$ to about 600,000 cd/m$^2$, or from about 90,000 cd/m$^2$ to about 500,000 cd/m$^2$.

The electroluminescent device of an embodiment may emit blue light, green light, or red light. The peak emission wavelength of the blue light, the peak emission wavelength of the green light, or the peak emission wavelength of the red light are the same as described herein.

In an embodiment, as measured by driving the device at a predetermined initial luminance (for example, about 650 nit), the electroluminescent device may exhibit a T50 of greater than or equal to about 200 hours, greater than or equal to about 250 hours, greater than or equal to about 300 hours, greater than or equal to about 350 hours, greater than or equal to about 400 hours, greater than or equal to about 450 hours, greater than or equal to about 500 hours, greater than or equal to about 550 hours, greater than or equal to about 600 hours, greater than or equal to about 650 hours, or greater than or equal to about 700 hours. The T50 may be from about 275 hours to about 4000 hours, from about 330 hours to about 2000 hours, from about 350 hours to about 1500 hours, from about 420 hours to about 1000 hours, or from about 430 hours to about 900 hours.

In an embodiment, as measured by driving the device at a predetermined initial luminance (for example, about 650 nit), the electroluminescent device may have a T90 of greater than or equal to about 5 hours, e.g., a T90 of greater than or equal to about 10 hours, greater than or equal to about 20 hours, greater than or equal to about 30 hours, greater than or equal to about 40 hours, greater than or equal to about 50 hours, greater than or equal to about 60 hours, greater than or equal to about 70 hours, greater than or equal to about 80 hours, greater than or equal to about 90 hours, greater than or equal to about 100 hours, greater than or equal to about 110 hours, greater than or equal to about 120 hours, greater than or equal to about 130 hours, greater than or equal to about 140 hours, greater than or equal to about 150 hours, greater than or equal to about 160 hours, greater than or equal to about 170 hours, greater than or equal to about 180 hours, greater than or equal to about 190 hours, or greater than or equal to about 200 hours. The T90 may be from about 55 hours to about 1500 hours, from about 62 hours to about 1000 hours, from about 75 hours to about 800 hours, from about 82 hours to about 700 hours, or any combination of the foregoing upper and lower limits.

On the measurement for the T90 or T50, the electroluminescent device may exhibit an initial current value of less than or equal to about 0.1 mA and an initial voltage of less than or equal to about 2.9 volts. The electroluminescent device of an embodiment has a relatively low initial driving current value and/or a relatively low initial driving voltage, which may suggest that the efficiency of the device is relatively high.

Another embodiment relates to a display device including the aforementioned electroluminescent device.

The display device may include a first pixel and a second pixel that emits light of a color differing from that of the first pixel. In the first pixel, the second pixel, or both, the electroluminescent device according to an embodiment may be disposed. In an embodiment, the display device may include a blue pixel, a red pixel, a green pixel, or a combination thereof. In the display device, the red pixel may include a red light-emitting layer including a plurality of red light-emitting semiconductor nanoparticles, the green pixel may include a green light-emitting layer including a plurality of green light-emitting semiconductor nanoparticles, and the blue pixel may include a blue light-emitting layer including a plurality of blue light-emitting semiconductor nanoparticles.

The display device or an electronic apparatus may include (or may be) a television, a virtual reality/augmented reality (VR/AR) device, a handheld terminal, a monitor, a notebook computer, an electronic display board, a camera, or a part for an automatic, e.g., autonomous, vehicle.

Specific examples are described below. However, the examples described below are only for specifically illustrating or explaining the disclosure, and the scope of the disclosure is not limited thereto.

Examples

1. Electroluminescence Measurement

A current according to an applied voltage is measured with a Keithley 2635B source meter, and a CS2000 spectrometer is used to measure electroluminescent properties (e.g., luminance and EQE) of a light-emitting device.

2. Life-span Characteristics

T50: As the device is started to be driven at a predetermined luminance (e.g., 650 nit), a time taken for a luminance of a given device to decrease to 50% of its initial luminance is measured.

T90: As the device is started to be driven at a predetermined luminance (e.g., 650 nit), a time taken for a luminance of a given device to decrease to 90% of its initial luminance is measured.

Initial current and initial voltage: The current provided to emit a certain initial luminance and the voltage measured when the current is provided.

3. XPS Analysis

XPS analysis is conducted using X-ray photoelectron spectrometer (manufacturer: Physical Electronics, model name: Quantum2000).

4. ICP-AES Analysis

Inductively coupled plasma atomic emission spectroscopy (ICP-AES) is performed using a Shimadzu ICPS-8100.

5. TEM analysis

A transmission electron microscopic analysis of the prepared nanoparticles is conducted using an UT F30 Tecnai electron microscope.

6. Photoluminescence Analysis and UV-Vis Spectroscopy

Photoluminescence (PL) analysis is conducted using a Hitachi F-7100 spectrophotometer.
A UV-Visible absorption spectroscopic analysis is conducted using a Shimadzu UV-2600 spectrophotometer and obtain a UV-Visible absorption spectrum. The bandgap energy can be obtained from the X-intercept value of the UV-Visible absorption spectrum based on the following equation:

$$\text{Bandgap energy (eV)} = 1240(\text{nm}) / \text{a value of a X-intercept value (nm)}$$

7. TGA analysis

A thermogravimetric analysis is conducted under a $N_2$ atmosphere using a Trios V3.2 system (TA Instruments) at a heating rate of 10 °C/min from 20 °C to 600 °C.

8. XRD analysis

An XRD pattern for the nanoparticle is obtained by using a D8 Advance (Bruker) instrument using a Cu Kα source.
The following synthesis is performed under an inert gas atmosphere (e.g., under nitrogen) unless otherwise specified. A precursor content is provided as a molar content, unless otherwise specified.

Synthesis Example 1:

2 moles per liter (M) of a Se/trioctylphosphine (TOP) stock solution, 1M of a S/TOP stock solution, and 0.1 M of a Te/TOP stock solution were prepared by dispersing selenium (Se), sulfur (S), and tellurium (Te) in trioctylphosphine (TOP), respectively. In a reactor containing trioctylamine, 0.125 millimoles (mmol) of zinc acetate was added to the reactor with oleic acid and heated at 120 °C under vacuum. After 1 hour, nitrogen was introduced into the reactor.
The reactor was heated to 240 °C, and the Se/TOP stock solution and the Te/TOP stock solution in a Te:Se mole ratio of 1:15 were rapidly added to, e.g., injected into, the reactor. When the reaction was complete, the reaction mixture rapidly cooled to room temperature, and acetone was added to facilitate formation of a precipitate. The mixture (suspension) was centrifuged to separate the solids, and then the solids were dispersed in toluene, obtaining a ZnSeTe core (dispersion in toluene).
1.8 mmol of zinc acetate were added together with oleic acid to a flask containing trioctylamine and the prepared mixture was heated at 120 °C under vacuum for 10 minutes. Nitrogen ($N_2$) was then introduced into the reactor, and the reactor was heated to 220 °C. The prepared ZnTeSe core particle dispersion was added quickly to the reactor, and the Se/TOP stock solution and the S/TOP stock solution were also added to the reactor at a mole ratio between Se and S of about 1:2, and the reactor temperature was raised to about 280 °C. After 2 hours, the reaction was complete, and the reactor was cooled to room temperature and ethanol was added to facilitate precipitation of the semiconductor nanoparticles, which were separated by centrifuge. The separated nanoparticle was dispersed in toluene.
The prepared semiconductor nanoparticles emitted blue light of about 460 nanometers (nm).

Preparation Example 1:

5 mmol of zinc acetate dihydrate, a magnesium acetate tetrahydrate powder, and aluminum chloride were added to a flask containing ethanol, and cyclohexane was added to prepare a first solution. The volume ratio between ethanol and cyclohexane was 1:0.5, an amount of the magnesium precursor was 0.176 mol per 1 mol of the zinc precursor, and an amount of the aluminum precursor was approximately 0.07 mol per 1 mol of a total of the zinc precursor and the magnesium precursor. A solution of 0.4 M potassium hydroxide in ethanol was added to the flask and reacted with stirring at room temperature for 60 minutes. Ethyl acetate was added to the first solution to facilitate precipitation, and the formed precipitation was centrifuged. The obtained particles were washed with hexane to obtain a zinc oxide nanoparticle containing aluminum and magnesium. The obtained nanoparticle was re-dispersed in ethanol and a transmission electron microscopy analysis was conducted. As a result, it was confirmed that the average size of the obtained particles was about 4 nm.

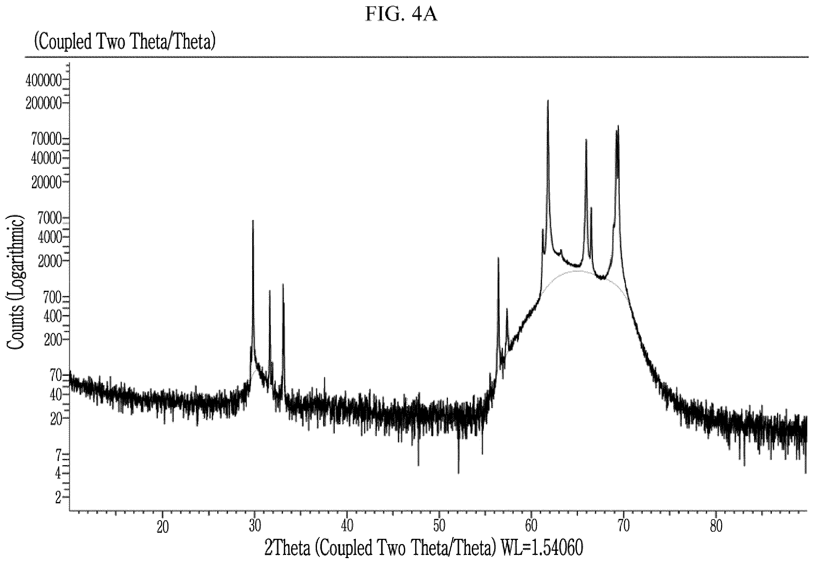

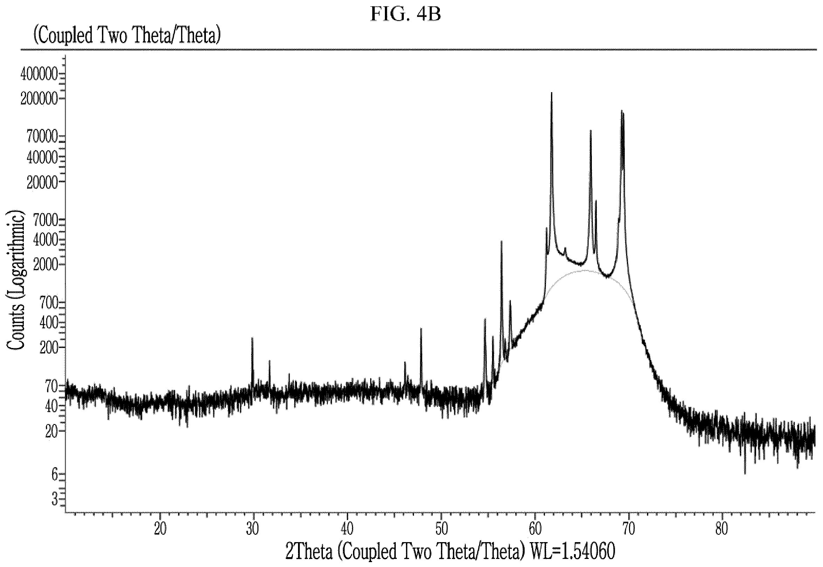

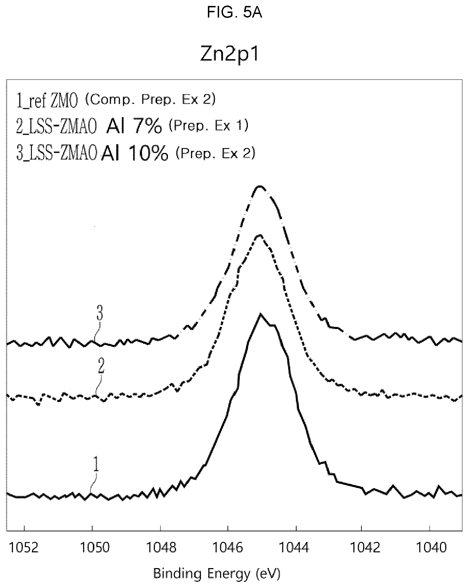

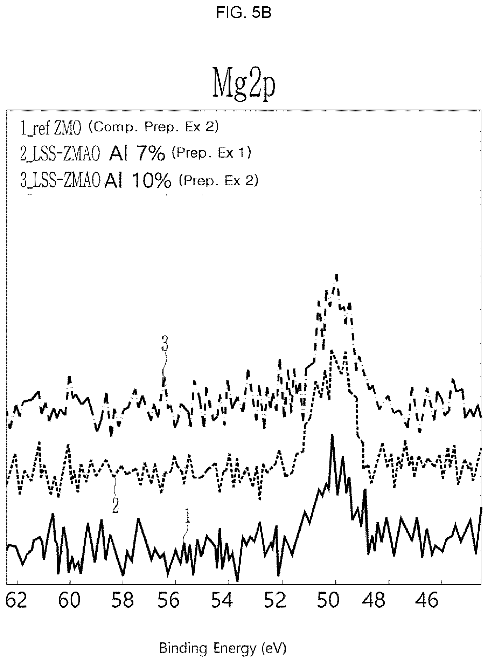

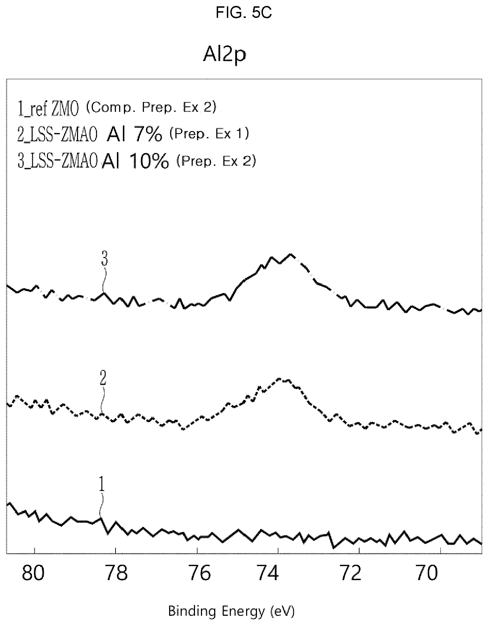

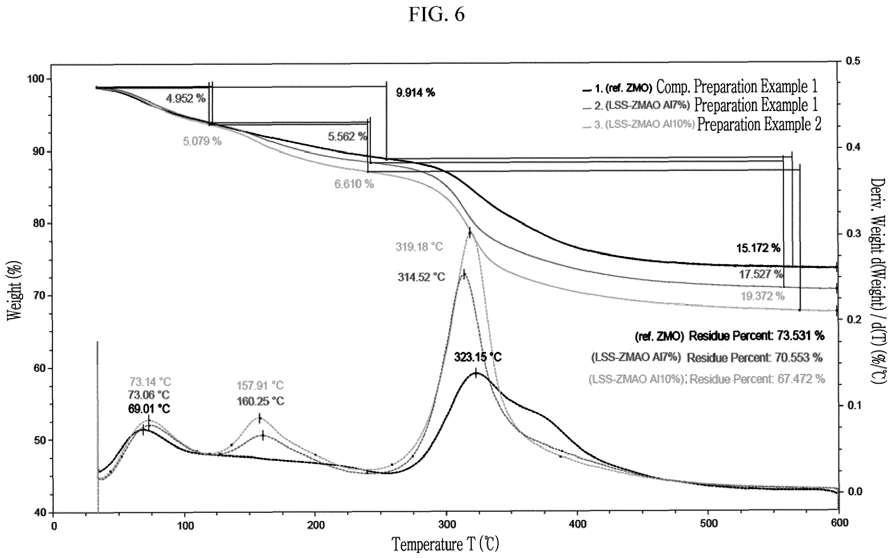

An ICP-AES analysis, a UV-Vis absorption spectroscopy, an X-ray diffraction analysis, and a XPS analysis were performed on the obtained nanoparticle, and the results are shown in Table 1, Table 2, and FIGS. 4, 5A, 5B, and 5C. A TGA analysis was performed, and the results are shown in FIG. 6. It was confirmed that the organic content was about 29.5 wt%.

The obtained nanoparticles were dispersed in ethanol to obtain a (transparent) coating solution for forming an electron transport layer (ETL), and a thin film was formed from the coating solution. It was confirmed that the prepared coating liquid passed through the 0.1 $\mu$m filter. It was confirmed that a relatively small number of voids were found in the formed thin film.

Preparation Example 2

A zinc oxide nanoparticle was prepared in the same manner as Preparation Example 1, except that an amount of the aluminum precursor was about 0.1 moles per one mole of a sum of the zinc precursor and the magnesium precursor.

An ICP-AES analysis, a UV-Vis absorption spectroscopy, an X-ray diffraction analysis, and a XPS analysis were performed on the obtained nanoparticle, and the results are shown in Table 1, Table 2, and FIGS, 5A, 5B, and 5C.

A TGA analysis was performed, and the results are shown in FIG. 6. It was confirmed that the organic content is about 32.5 wt%.

Preparation Example 3

A zinc oxide nanoparticle was prepared in the same manner as Preparation Example 1, except that an amount of the aluminum precursor was about 0.15 moles per one mole of a sum of the zinc precursor and the magnesium precursor. A transmission electron microscopy analysis of the obtained nanoparticles was performed, and the results confirmed that the average size of the particles was about 3.5 nm.

An ICP-AES analysis, a UV-Vis absorption spectroscopy, an X-ray diffraction analysis, and an XPS analysis were performed on the obtained nanoparticle, and the results are shown in Table 1 and Table 2.

Preparation Example 4

A zinc oxide nanoparticle including magnesium and aluminum was prepared in the same manner as Preparation Example 1, except that zinc acetate dihydrate, magnesium acetate tetrahydrate, and aluminum chloride were dissolved in dimethyl sulfoxide as a solvent instead of ethanol and cyclohexane and an aqueous solution of tetramethylammonium hydroxide pentahydrate were added thereto to conduct a reaction for forming the nanoparticle. Transmission electron microscope analysis of the obtained nanoparticles was performed. As a result, it is confirmed that the average size of the nanoparticles thus obtained was about 3.5 nm.

An ICP-AES analysis, a UV-Vis absorption spectroscopy, and an X-ray diffraction analysis were performed on the obtained nanoparticle, and the results are shown in Table 1 and Table 2, and FIG. 4B.

The obtained nanoparticles were dispersed in ethanol to obtain a coating solution for forming an ETL, and a thin film was formed from the coating solution. It was confirmed that the prepared coating liquid passed through the 0.45 $\mu$m filter but failed to pass through the 0.1 $\mu$m filter. It was confirmed that the formed thin film had voids.

FIGS. 4A and 4B confirmed that the zinc oxide nanoparticles prepared from Preparation Example 1 may exhibit increased crystallinity in comparison with the zinc oxide nanoparticles prepared from Preparation Example 4. Specifically, in X-ray diffraction analysis, the zinc oxide nanoparticle prepared from Preparation Example 1 showed that the maximum intensity ratio (B/A, 0.07, or 7%) of the maximum intensity (B) of the peak in the range of 25 to 35 degrees (e.g., approximately 7000) to the maximum intensity (A) of the peak in the range of 65 to 75 degrees (e.g., approximately 100,000) of the 2 theta angle was significantly greater than that of the zinc oxide nanoparticles prepared from Preparation Example 4.

Preparation Example 5

A zinc oxide nanoparticle was prepared in the same manner as Preparation Example 1, except that an amount of the aluminum precursor was about 0.03 moles per one mole of a sum of the zinc precursor and the magnesium precursor.

An ICP-AES analysis and a UV-Vis absorption spectroscopy were performed on the obtained nanoparticle, and the results are shown in Table 1 and Table 2.

Comparative Preparation Example 1

Zinc acetate dihydrate and magnesium acetate tetrahydrate were added to a reactor containing dimethyl sulfoxide and heated to 60 °C in a nitrogen atmosphere. Subsequently, an aqueous solution of tetramethylammonium hydroxide pentahydrate was added to the reactor. An amount of the magnesium precursor per a mole of the zinc precursor was 0.176 mol. After stirring for 1 hour, the formed precipitate was centrifuged and dispersed in ethanol to obtain ZnMgO nanoparticles. A transmission electron microscopy analysis of the obtained nanoparticles was performed. The results confirmed that the average size of the particles was approximately 3 nm.

A TGA analysis was performed to measure the organic material content, and it was confirmed that the organic material content exceeded 26%.

An ICP-AES analysis and a UV-Vis absorption spectroscopy were performed on the obtained nanoparticles, and the results are shown in Table 1.

Comparative Preparation Example 2

A zinc oxide nanoparticle was prepared in the same manner as Preparation Example 1, except for not using the aluminum precursor.

An XPS analysis was performed on the obtained nanoparticles and the results are shown in Table 2.

Table 1

| | A first absorption wavelength (nm) | ICP (a mole percentage based on a total amount of zinc, magnesium, and aluminum) | | |
| --- | --- | --- | --- | --- |
| | | Zn | Mg | Al |
| Preparation Example 1 | 315 | 84% | 11% | 5% |
| Preparation Example 2 | 318 | 81% | 12% | 7% |
| Preparation Example 3 | 323 | 55% | 30% | 15% |
| Preparation Example 4 | 305 | 88% | 10% | 2% |
| Preparation Example 5 | 319 | 86% | 11% | 3% |
| Comp. Preparation Example 1 | 300 | 89% | 11% | 0% |
| Comp. Preparation Example 2 | 303 | 85% | 15% | 0% |

Table 2

| | Atomic concentration (at %) | |
| --- | --- | --- |
| | Al2p | K2p |
| Preparation Example 1 | 1 | 0.81 |
| Preparation Example 2 | 1.57 | 0.99 |
| Comp. Preparation Example 2 | 0 | 0.68 |

From the results of Table 1, it was confirmed that the zinc oxide nanoparticles prepared in Preparation Examples contained aluminum in a predetermined molar content, and had a first absorption peak wavelength different from that of Comparative Example. From the results of Table 2, it was confirmed that the zinc oxide nanoparticles prepared in the Preparation Examples further contained potassium.

Production of Electroluminescent Device

Example 1

A semiconductor nanoparticle solution prepared by dispersing the semiconductor nanoparticles prepared in Synthesis Example 1 in octane was prepared. An ETL dispersion was prepared by dispersing the zinc oxide nanoparticles prepared in Preparation Example 1 in ethanol.

An electroluminescent device (ITO/PEDOT:PSS (35 nm)/TFB (25 nm)/QD light-emitting layer (20 nm)/ETL (20 nm)/Al (100 nm)) was produced according to the following method.

After surface-treating a glass substrate deposited with ITO with UV-ozone for 15 minutes, a PEDOT:PSS solution (H.C. Starks, Inc.) was spin-coated thereon and heat-treated at 150 °C for 10 minutes under an air atmosphere and then, at 150 °C for 20 to 30 minutes under an $N_2$ atmosphere to form a 35 nm-thick hole injection layer.

On the hole injection layer, a poly[(9,9-dioctylfluorenyl-2,7-diyl-co (4,4'-(N-4-butylphenyl)diphenylamine] solution (TFB) (Sumitomo Corp.) was spin-coated and heat-treated at 150 °C for 30 minutes, forming a 25 nm-thick hole transport layer.

On the hole transport layer, the semiconductor nanoparticle solution was spin-coated to form a 20 nm-thick light-emitting layer.

On the light-emitting layer, the ETL dispersion was spin-coated and heat-treated for 30 minutes, forming an electron transport layer (thickness: 20 nm).

On the obtained electron transport layer, aluminum (Al) was vacuum-deposited to be 100 nm thick, forming a second electrode and thus producing an electroluminescent device.

Electroluminescent properties and a life-span of the produced electroluminescent device were measured and the results are shown in Table 3 and Table 4.

Regarding the measurement of the life span of the manufactured electroluminescent device, it was also confirmed that the initial driving current of the manufactured device was less than 0.1 mA (e.g., 0.09 mA) and the initial driving voltage was 2.8 volts.

Example 2

An electroluminescent device was manufactured in the same manner as in Example 1 except that an ETL dispersion prepared by dispersing the zinc oxide nanoparticles of Preparation Example 2 in ethanol was used.

Electroluminescent properties and a life-span of the produced electroluminescent device were measured and the results are shown in Table 3 and Table 4.

Example 3

An electroluminescent device was manufactured in the same manner as in Example 1 except that an ETL dispersion prepared by dispersing the zinc oxide nanoparticles of Preparation Example 3 in ethanol was used.

Electroluminescent properties of the produced electroluminescent device were measured and the results are shown in Table 3.

The lifespan of the manufactured electroluminescent device was measured, and the result confirmed that the manufactured device had a lower lifespan (of about 70 hours or lower) than that of Example 1 or Example 2.

Example 4

An electroluminescent device was manufactured in the same manner as in Example 1 except that an ETL dispersion prepared by dispersing the zinc oxide nanoparticles of Preparation Example 4 in ethanol was used.

Electroluminescent properties of the produced electroluminescent device were measured and the results are shown in Table 3.

The life span of the manufactured electroluminescent device was measured, and the results confirmed that the manufactured device had a lower life span (T90 of less than 100 hours and approximately 70 hours) than the device of Example 1 or Example 2.

It was also confirmed that the initial driving current of the manufactured device was 0.12 mA and the initial driving voltage was 2.9 volts.

Comparative Example 1

An electroluminescent device was manufactured in the same manner as in Example 1 except that an ETL dispersion prepared by dispersing the zinc oxide nanoparticles of Comparative Example 1 in ethanol was used.
Electroluminescent properties of the produced electroluminescent device were measured and the results are shown in Table 3 and Table 4.
Regarding the measurement of the life span of the manufactured electroluminescent device, it was also confirmed that the initial driving current of the manufactured device was 0.12 mA and the initial driving voltage was 2.8 volts.

Comparative Example 2

An electroluminescent device was manufactured in the same manner as in Example 1 except that an ETL dispersion prepared by dispersing the zinc oxide nanoparticles of Comparative Example 2 in ethanol was used.
Electroluminescent properties of the produced electroluminescent device were measured and the results are shown in Table 3.

Table 3

|  | Zinc oxide nanoparticles included in the electron transport layer | Max EQE (%) | Max luminance Cd/m$^2$ |
| --- | --- | --- | --- |
| Example 1 | Preparation Example 1 | 13.2% | 137397 |
| Example 2 | Preparation Example 2 | 14.3% | 105082 |
| Example 3 | Preparation Example 3 | 7.2% | 81647 |
| Example 4 | Preparation Example 4 | 9% | about 100,000 |
| Comp. Example 1 | Comp. Preparation Example 1 | 7.1% | 72596 |
| Comp. Example 2 | Comp. Preparation Example 2 | 5.3% | 63871 |

From the results of Table 3, it was confirmed that the electroluminescent devices of Examples 1 to 4 exhibit improved electroluminescent properties compared to the device of Comparative Example 1.

Table 4

|  | nanoparticles included in the electron transport layer | T90 (hour) | T50 (hour) |
| --- | --- | --- | --- |
| Example 1 | Preparation Example 1 | 120 | 615 |
| Example 2 | Preparation Example 2 | 133 | 650 |
| Comp. Example 1 | Comp. Preparation Example 1 | 56 | 150 |
| Comp. Example 2 | Comp. Preparation Example 2 | Less than 50 hours | - |

From the results of Table 4, it was confirmed that the electroluminescent devices of Examples 1 and 2 exhibit improved life span feature compared to the device of Comparative Example 1 and Comparative Example 2.
While this disclosure has been described in connection with what is presently considered to be practical embodiments, it is to be understood that the invention is not limited to the disclosed embodiments. On the contrary, it is intended to cover various modifications and equivalent arrangements included within the scope of the appended claims.

Claims

1. An electroluminescent device comprising:

a first electrode and a second electrode spaced apart from each other;
a light-emitting layer disposed between the first electrode and the second electrode; and
an electron transport layer disposed between the light-emitting layer and the second electrode,
wherein the light-emitting layer comprises a semiconductor nanoparticle,
wherein the electron transport layer comprises a zinc oxide nanoparticle,
wherein the zinc oxide nanoparticle has a size of greater than or equal to 1 nanometer and less than or equal to 15 nanometers,
wherein the zinc oxide nanoparticle further comprises magnesium and aluminum, and in the zinc oxide nanoparticle, an amount of aluminum is greater than or equal to 0.5 mol% and less than or equal to 30 mol%, based on the total moles of zinc, magnesium, and aluminum.

2. The electroluminescent device of claim 1, wherein the semiconductor nanoparticle does not comprise cadmium; and/or
wherein in the zinc oxide nanoparticle, an amount of aluminum is greater than or equal to 2.7 mol% and less than or equal to 20 mol%, based on the total moles of zinc, magnesium, and aluminum.

3. The electroluminescent device of claims 1 or 2, wherein in the zinc oxide nanoparticle,

a mole ratio of aluminum to zinc (Al:Zn) is greater than or equal to 0.01:1, and less than or equal to 0.5:1; or
a mole ratio of magnesium to zinc (Mg:Zn) is greater than or equal to 0.1:1, and less than or equal to 0.7:1.

4. The electroluminescent device of any of claims 1-3, wherein in the zinc oxide nanoparticle,

a mole ratio of aluminum to magnesium (Al:Mg) is greater than or equal to 0.1:1 and less than or equal to 1.5:1; or
a mole ratio of a sum of aluminum and magnesium to zinc [(Al + Mg):Zn] is greater than or equal to 0.1:1 and less than or equal to 1.5:1

5. The electroluminescent device of any of claims 1-4, wherein the electron transport layer is disposed adjacent to the light-emitting layer; and/or

wherein in an X-ray diffraction analysis of the zinc oxide nanoparticle, a peak percentage defined by the following equation is greater than or equal to 3%:

$$\text{Peak percentage (\%)} = [B/A] \times 100,$$

wherein A is a maximum intensity of a peak present in a 2 theta range of from 65 degrees to 75 degrees, and
wherein B is a maximum intensity of a peak present in a 2 theta range of from 25 degrees to 35 degrees.

6. The electroluminescent device of any of claims 1-5, wherein the zinc oxide nanoparticle further comprises a halogen; and/or
wherein the zinc oxide nanoparticle further comprises an additional metal, and the additional metal comprises an alkali metal, Ca, Zr, W, Ga, Ti, Y, or a combination thereof.

7. The electroluminescent device of any of claims 1-6, wherein the zinc oxide nanoparticle is dispersible in a C1 to C10 alcohol solvent.

8. The electroluminescent device of any of claims 1-7,
wherein in a UV-Vis absorption spectroscopy analysis, the zinc oxide nanoparticle has a first absorption peak wavelength in a range of greater than or equal to 310 nm and less than or equal to 323 nm.

9. The electroluminescent device of any of claims 1-8,

wherein the zinc oxide nanoparticle further comprises an alkali metal; and
wherein the alkali metal comprises potassium, rubidium, cesium, or a combination thereof, and
in the zinc oxide nanoparticle, a mole ratio of the alkali metal to the aluminum is greater than or equal to 0.1:1 and less than or equal to 1.5:1.

**10.** The electroluminescent device of any of claims 1-9,

wherein the electroluminescent device emits blue light when a voltage is applied;
wherein
the electroluminescent device has a maximum external quantum efficiency of greater than or equal to 8 percent and less than or equal to 40 percent, or
the electroluminescent device shows a maximum luminance of greater than or equal to 80,000 candelas per square meter and less than or equal to 500,000 candelas per square meter.

**11.** The electroluminescent device of any of claims 1-10,
wherein the electroluminescent device exhibits a T90 of greater than or equal to 60 hours and less than or equal to 1000 hours, as measured at an initial luminance of 650 nit.

**12.** A display device comprising the electroluminescent device of any of claims 1-11;
preferably wherein the display device is a handheld terminal device, a monitor, a notebook computer, a television, an electronic display board, a camera, or an electronic component for an automatic vehicle.

**13.** A method of producing an electroluminescent device of any of claims 1-11, the method comprising:

disposing the light-emitting layer on the first electrode;
applying a composition comprising a zinc oxide nanoparticle on the light-emitting layer to form the electron transport layer; and
disposing the second electrode on the electron transport layer to produce the electroluminescent device,
wherein a preparation of the zinc oxide nanoparticle comprises
admixing a zinc precursor, a magnesium precursor, and aluminum precursor with a first solvent and a second solvent to obtain a first solution;
adding a base to the first solution to form to the zinc oxide nanoparticle;
wherein a relative polarity difference between the first solvent and the second solvent is greater than or equal to 0.25 and less than or equal to 0.9;
preferably wherein the first solvent comprises a C1 to C10 alcohol solvent, and the second solvent comprises a substituted or unsubstituted C3 to C30 hydrocarbon solvent, a C3 to C10 ester solvent, chloroform, a C2 to C30 ketone solvent, dioxane, or a combination thereof.

**14.** The method of claim 13, wherein the base comprises an inorganic compound comprising an alkali metal; or
wherein the aluminum precursor comprises an aluminum halide.

**15.** The method of claims 13 or 14, wherein the obtaining of the first solution comprises adding the zinc precursor, the magnesium precursor, and the aluminum precursor into the first solvent to dissolve the precursors and adding the second solvent to a resulting mixture.

FIG. 1

FIG. 2

FIG. 3

## FIG. 4A

(Coupled Two Theta/Theta)

2Theta (Coupled Two Theta/Theta) WL=1.54060

FIG. 4B

(Coupled Two Theta/Theta)

Counts (Logarithmic)

400000
200000

70000
40000

20000

7000
4000

2000

700
400

200

70
40

20

6

3

20    30    40    50    60    70    80

2Theta (Coupled Two Theta/Theta) WL=1.54060

FIG. 5A

# Zn2p1

1_ref ZMO (Comp. Prep. Ex 2)
2_LSS-ZMAO Al 7% (Prep. Ex 1)
3_LSS-ZMAO Al 10% (Prep. Ex 2)

Binding Energy (eV)

FIG. 5B

# Mg2p

1_ref ZMO (Comp. Prep. Ex 2)
2_LSS-ZMAO Al 7% (Prep. Ex 1)
3_LSS-ZMAO Al 10% (Prep. Ex 2)

Binding Energy (eV)

FIG. 5C

## Al2p

1_ref ZMO (Comp. Prep. Ex 2)
2_LSS-ZMAO Al 7% (Prep. Ex 1)
3_LSS-ZMAO Al 10% (Prep. Ex 2)

Binding Energy (eV)

FIG. 6

Europäisches
Patentamt

European
Patent Office

Office européen
des brevets

# EUROPEAN SEARCH REPORT

**Application Number**

EP 24 15 0031

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | CN 109 825 285 A (SUZHOU XINGSHUO NANOTECH CO LTD) 31 May 2019 (2019-05-31) * claims 1-10; examples 1-7 * | 1-15 | INV. H05B33/14 H05B33/22 |
| A | US 2021/043864 A1 (LI DONG [CN]) 11 February 2021 (2021-02-11) * paragraph [0044]; claims 1-20 * | 1-15 | |
| A | WO 2022/199037 A1 (TCL TECH GROUP CORP [CN]) 29 September 2022 (2022-09-29) * claims 1-20 * | 1-15 | |

**TECHNICAL FIELDS SEARCHED (IPC)**

H05B

The present search report has been drawn up for all claims

| Place of search | Date of completion of the search | Examiner |
|---|---|---|
| The Hague | 14 May 2024 | Lehnert, Andreas |

EPO FORM 1503 03.82 (P04C01)

## ANNEX TO THE EUROPEAN SEARCH REPORT
## ON EUROPEAN PATENT APPLICATION NO.

EP 24 15 0031

This annex lists the patent family members relating to the patent documents cited in  the above-mentioned European search report.
The members are as contained in the European Patent Office EDP file on
The European Patent Office is in no way liable for these particulars which are merely given for the purpose of information.

14-05-2024

| Patent document cited in search report | | Publication date | Patent family member(s) | | Publication date |
|---|---|---|---|---|---|
| CN 109825285 | A | 31-05-2019 | NONE | | |
| US 2021043864 | A1 | 11-02-2021 | CN | 109728179 A | 07-05-2019 |
| | | | US | 2021043864 A1 | 11-02-2021 |
| | | | WO | 2020140760 A1 | 09-07-2020 |
| WO 2022199037 | A1 | 29-09-2022 | CN | 115117284 A | 27-09-2022 |
| | | | WO | 2022199037 A1 | 29-09-2022 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- Solvents and solvent Effects in organic chemistry. Wiley VCH publisher, 2003